(19) Europäisches Patentamt
European Patent Office
Office européen des brevets

(11) Publication number: **0 360 442 B1**

(12) # EUROPEAN PATENT SPECIFICATION

(45) Date of publication of patent specification: **20.07.94**

(51) Int. Cl.$^5$: **H03L 7/189**, H03L 7/14

(21) Application number: **89308858.3**

(22) Date of filing: **01.09.89**

(54) **Frequency sythesizer.**

(30) Priority: **02.09.88 JP 218586/88**
**07.10.88 JP 254199/88**
**18.11.88 JP 291999/88**

(43) Date of publication of application:
**28.03.90 Bulletin 90/13**

(45) Publication of the grant of the patent:
**20.07.94 Bulletin 94/29**

(84) Designated Contracting States:
**DE FR GB SE**

(56) References cited:
**EP-A- 0 041 882**
**FR-A- 2 356 332**
**US-A- 4 410 860**

(73) Proprietor: **Nippon Telegraph and Telephone Corporation**
**1-6 Uchisaiwaicho 1-chome**
**Chiyoda-ku**
**Tokyo 100(JP)**

(72) Inventor: **Tarusawa, Yoshiaki**
**4622-3-A-404, Kamariya-cho**
**Kanazawa-ku**
**Yokohama-shi Kanagawa 236(JP)**
Inventor: **Saito, Shigeki**
**1-28-D-909, Deiki**
**Kanazawa-ku**
**Yokohama-shi Kanagawa 236(JP)**
Inventor: **Yamao, Yasushi**
**510-7-5-101, Tsukui**
**Yokosuka-shi Kanagawa 239(JP)**
Inventor: **Nojima, Toshio**
**2-25-13 Hairando**
**Yokosuka-shi Kanagawa 239(JP)**

(74) Representative: **Darby, David Thomas et al**
**Abel & Imray**
**Northumberland House**
**303-306 High Holborn**
**London WC1V 7LH (GB)**

Note: Within nine months from the publication of the mention of the grant of the European patent, any person may give notice to the European Patent Office of opposition to the European patent granted. Notice of opposition shall be filed in a written reasoned statement. It shall not be deemed to have been filed until the opposition fee has been paid (Art. 99(1) European patent convention).



Rank Xerox (UK) Business Services
(3.10/3.09/3.3.3)

## Description

[Technical Field]

This invention relates to a frequency synthesizer to be used for multichannel access type systems. More particularly, this invention relates to a frequency synthesizer which has a high frequency stability and a low phase noise, and is capable of high speed switching of oscillation frequency. More specifically, this invention relates to a frequency synthesizer which is constructed to use a phase-locked loop (PLL), and is adapted to supply a steering voltage to a voltage-controlled oscillator from outside of the phase locked loop (PLL) at the oscillation frequency switching in order to shorten the settling time of PLL.

This invention is suitable for application as a local oscillator or a carrier oscillator in a radio transmitter/receiver.

[Background Technology]

Frequency domain multichannel access system is widely used in recent years to satisfy a large number of call requests without failure and to increase utilization efficiency of frequencies. The multichannel access system is characterized in that a large number of channels are used to construct the system which is allocated to a large number of subscribers so that a subscriber may use a vacant channel within the system for his/her call. This system requires a frequency synthesizer which is capable of switching a large number of frequencies easily. It is desirable to reduce the time required for frequency switching in order to realize non-interruption h andover during the communication.

Frequency synthesizer using PLL (phase-locked loop) is currently the most prevailing type. A PLL frequency synthesizer phase-locks the output signals from a voltage controlled oscillator (VCO) and the output signals from a reference oscillator. Therefore, is a reference oscillator with a high frequency stability is used, an output with extremely stable frequency can be obtained in the static state. Frequency is switched by changing the division ratio set at a frequency divider inside the PLL. The time required for switching frequencies of PLL frequency synthesizer is determined by the closed-loop bandwidth which is dependent on the reference frequency, phase detector gain, etc. Especially when output frequencies spacing has to be set narrowly, closed-loop bandwidth cannot be increased, because the division ratio requirs a large value.

Frequency switching of PLL frequency synthesizer and the conventional method for reducing the time of frequency switching will be described below.

FIG. 1 is a block diagram to show the construction of a conventional PLL frequency synthesizer. The frequency synthesizer comprises a phase detector 1, a variable ratio divider 2, a loop filter 3, and a voltage controlled oscillator 4 (hereinafter referred to as VCO). Each circuit forms a phase locked loop PLL) wherein the output phase of VCO 4 is synchronized with the phase of the reference signal in the static state. If it is assumed that the frequency of the reference signal is denoted as $f_r$, the output frequency of VCO 4 as $f_o$, and the division ratio of the variable ratio divider 2 as N, the output frequency $f_o$ in the phase locked state (or static state) can be expressed as the equation (1)

$$f_o = N^*f_r \qquad (1)$$

The output frequency may be switched from $f_{o1}$ to $f_{o2}$ by switching the division ratio from $N_1$ to $N_2$. If a stable reference signal is supplied, plural stable frequencies may be obtained by switching the division ratio set at the divider 2. For instance, if the reference signal $f_r$ is 12.5 kHz, the output frequency may be step stepwise from 1.60 GHz to 1.625 GHz by varying the division ratio N from 128,000 to 130,000.

FIG. 2 shows an example of transient behaviors of the PLL frequency synthesizer at the frequency switching. More specifically, when the division ratio set at the divider 2 is switched at the time $t_o$, the output frequency needs a certain time (time for switching frequency) before it reaches a target frequency $f_{o2}$. During the transient time, voltage $V_c$ of the capacitor in a loop filter 3 in FIG. 1 changes from $V_{c1}$ to $V_{c2}$ as shown in FIG. 2. The frequency switching time needs to include at least the time for charging/discharging the capacitor. For instance, if it is assumed that the output frequency is in the 1.6 GHz band and the reference signal frequency is 12.5 kHz, the time required is in the range of 50 ms.

In order to reduce the frequency switching time, there has been proposed a frequency synthesizer having the construction shown in FIG. 3. The construction differs from that of the synthesizer of FIG. 1 in that it is provided with a D/A converter 6 and an adder 5. The adder 5 outputs the sum of the output voltage $V_{da}$ of the D/A converter 6 and the output from the loop filter 3 as the output in steering voltage $V_s$ of VCO

4. As no electric current passes through the resistors $R_1$ and $R_2$ in FIG. 3 in the static state, the voltages $V_c$ of the capacitor becomes identical to the output from the loop filter 3. Accordingly, the steering voltage Vs of VCO 4 can be expressed by the equation (2)

$$V_s = V_c + V_{da} \quad (2)$$

It is assumed that the current output frequency is denoted as $f_{o1}$, and the steering voltage for VCO 4 correponding thereto as $V_{s1}$ . If the relation $V_{da} = V_{s1}$ holds, it will hold that $V_c = 0$. If the frequency is to be switched from $f_{o1}$ to $f_{o2}$, the division ratio of the variable ratio divider 2 should be switched from $N_1$ to $N_2$. In the static state after switching, the VCO controlling voltage corresponding to the frequency $f_{o2}$ is assumed to be $V_{s2}$ , and if the relation $V_{da} = V_{s2}$ is set as soon as the division ratio is switched, the relation $V_c = 0$ holds or the voltage of the capacitor stays at the 0 volt. This reduces the charging/discharging time of the capacitor in the loop filter. The transient behavior would be the same as that of the construction shown in FIG. 1 if the voltage Vda is unchanged despite the frequency switching. By using the construction of FIG. 3, the time necessary to switch frequency is shortened as shown in FIG. 4.

The operation will be further analyzed below. In VCO, the relation between the output frequency f and the steering voltage $V_s$ is varied due to changes in temperature, etc. It is assumed that the behavior at the time of frequency switching shows linear voltage controlled characteristics as shown in Fig. 5. The frequency variation of VCO is extreme small compared to the oscillation frequency, and the frequency drift $\Delta f_o$ could be regarded constant irrespective of the steering voltage $V_s$ . In FIG. 5, at the time $t = t_o$, and when the output frequency $f_o$ is $f_{o1}$, the steering voltage $V_s$ would be $V_{s1}$ . When the output frequency of VCO changes by the drift $\Delta f_o$, the steering voltage $V_s$ decreases by the drift compensation voltage $\Delta V_s$ by the operation of PLL so as to maintain the output frequency at $f_{o1}$. More particularly, drift compensation voltage $-\Delta V_c$ ($= -\Delta V_s$) necessary to compensate the frequency drift $\Delta f_o$ is generated at the capacitor in the loop filter. The output frequency can be fast switched from $f_{o1}$ to $f_{o2}$ by setting a steering voltage $V_{s2}$ at the D/A converter disregarding the drift compensation voltage $\Delta V_c$. The VCO steering voltage is set at a value corresponding to a desired frequency ($V_{s2} - \Delta V_s$). In this way, frequency may be switched without changing the voltage at the capacitor.

However, even though the frequency change is maintained constant irrespective of the steering voltage, the relation between the steering voltages of VCO and the output frequencies $f_o$ is not necessarily linear as shown in FIG. 5. For instance, the electrical tuning capacitor C of the VCO is made by a varactor diode. In this case, the drift compensation voltage $\Delta V_{s1}$ caused by the frequency drift $\Delta f_o$ at $f_{o1}$ is different from the drift compensation voltage $\Delta V_{s2}$ at $f_{o2}$ as shown in FIG. 6. Therefore at the frequency switching, if the steering voltage $V_{s2}$ is at as it is, there will be caused errors equivalent to the difference of the drift compensation voltages $\Delta V_{s1}$ and $\Delta V_{s2}$, and PLL works to charge/discharge the capacitor in order to compensate the difference. Therefore, the time required for frequency switching is not quite reduced heretofore.

Moreover, the reference signal phase and the output phase of the variable ratio divider do not always agree immediately after the controlling voltage data is set in the D/A converter. PLL works to cancel the phase errors to thereby vary the output frequency as shown in FIG. 4.

Because of those reasons, the time required for frequency switching could not heretofore be reduced beyond a certain time.

This invention was conceived to eliminate such problems encountered in the prior art and aims to provide a frequency synthesizer which is capable of high speed switching of oscillation frequency.

European Patent Application No. 0 041 882 discloses a radio frequency synthesizer employing a phase locked loop including a voltage controlled oscillator the operating frequency which is set by a selected one of a plurality of preset voltages obtained from a memory arrangement that is capable of providing voltages in accordance with a non-linear voltage-frequency characteristic of the voltage controlled oscillator. The stated purpose of the arrangement disclosed in European Patent Application No. 0 041 882 is to improve the speed with which the synthesizer achieves a stable output at the selected frequency or, alternatively, to reduce the time it takes to provide a stable output at the selected frequency.

United States Patent No. 4 410 860 discloses a radio frequency synthesizer employing a phase locked loop with a memory circuit that stores the control voltage required by its voltage controlled oscillator to provide a selected operating frequency once that operating frequency has been generated; that control voltage is recalled when, in the future, that operating frequency is again selected. The stated purpose of the arrangement disclosed in United States Patent No. 4 410 860 is the reduction in the acquisition time of the synthesizer.

French Patent Application No. 2 356 332 discloses a radio frequency synthesizer employing a phase locked loop which includes a loop filter of controllable bandwidth, the loop filter being capable of being set to operate with a short time constant when a new frequency is being acquired and to operate with a long time constant when a selected frequency is being maintained.

The present invention provides a frequency synthesizer which changes frequency with substantially no phase error between the reference signal and the output from the divider by resetting the variable ratio divider at each change in frequency.

The invention provides a frequency synthesizer including a voltage controlled oscillator, a variable ratio divider which operates on the output from the voltage controlled oscillator, a phase detector which compares the output phase of the variable ratio divider with the phase of reference signal, a loop filter which smooths the output from the detector and supplies it to the voltage controlled oscillator, and an oscillation frequency switching means which changes the frequency of the voltage controlled oscillator by changing the division ratio of the variable ratio divider, wherein the oscillator frequency switching means includes a voltage supply means which supplies a frequency setting steering voltage to the voltage controlled oscillator via a D/A converter in synchronization with the change in the division ratio of the variable ratio divider, characterized in that the variable ratio divider has a reset means, and the oscillation frequency switching means includes a means which resets the variable ratio divider by using the reference signal at the phase detector as a trigger.

Preferably, a loop switch is provided at an input of the loop filter, and the oscillation frequency switching means includes a means which opens the loop switch before switching the oscillation frequency and closes the loop switch after the variable ratio divider is reset.

Preferably, the frequency synthesizer includes a sample-hold circuit connected to an output of the D/A converter and a means which stops the supply of power to the D/A converter after a sample of the steering voltage is held at the sample-hold circuit.

Preferably, the sample-hold circuit includes a capacitor that is a component element of the loop filter.

Preferably, a variable bandwidth filter is connected to an output of the D/A converter, and the oscillation frequency switching means includes a bandwidth limiting means which reduces the bandwidth of the variable bandwidth filter after the change in the oscillation frequency.

Alternatively, a variable bandwidth filter may be connected to an input of the voltage controlled oscillator, and the oscillation frequency means may include a bandwidth limiting means which reduces the bandwidth of the variable bandwidth filter after the change of the oscillation frequency.

Preferably, the output of the D/A converter is connected to a low-pass filter and the voltage supply means includes a means which causes the D/A converter to provide a plurality of voltages alternating above and below the steering voltage corresponding to the required frequency in advance of providing the steering voltage corresponding to the required frequency.

In one embodiment, the voltage controlled oscillator has an oscillator frequency corresponding non-linearly to the input steering voltage, a voltage measuring means is provided for measuring the voltage supplied from the loop filter to the voltage controlled oscillator, and the voltage supply means includes a steering voltage compensation means which applies a correction to the steering voltage supplied to the voltage controlled oscillator, when its frequency is changed, in order to compensate for the non-linearity of the voltage controlled oscillator, the correction to the steering voltage being based on the value measured by the voltage measurement means before the change in frequency.

Preferably, the steering voltage correction means generates a voltage equal to $[V_{S2} - (\Delta V_{S2} - \Delta V_{S1})]$ when the oscillator frequency is $f_2$, where $\Delta V_{S1}$ represents the voltage obtained by the voltage measurement means when the oscillator frequency is $f_1$, $V_{S2}$ represents the frequency-setting steering voltage required to generate the frequency $f_2$ without drift compensation, and $\Delta V_{S2}$ represents the voltage required to compensate for the drift of the oscillator at the frequency $f_2$, where $f_2 > f_1$.

The phase errors caused by changes in the oscillation frequency are reduced in comparison with known arrangements by resetting the variable ratio divider at changes in the oscillation frequency and by generating the steering voltage in a manner that does not lead to variation in the output voltage of the loop filter.

Accordingly, the time necessary to switch frequency can be remarkably shortened.

When a variable bandwidth filter is used, the bandwidth should be set wide at the time of changing the oscillation frequency and set narrow once the loop has settled. The wideband filter setting allows the supply of a steering voltage that rises quickly at the time of switching and the narrow band filter setting used after the oscillation frequency changes prevents noise from the D/A converter provided within the voltage supply means from being transmitted to the voltage controlled oscillator.

The D/A converter may be separated from the phase-locked loop after frequency switching and the capacitor of the loop filter used as a sample-hold circuit in order to provide a quickly rising steering voltage at the time of switching without having to tolerate the noise from the D/A converter at other times.

In other words the digital-analog converter which might introduce noise into the voltage controlled oscillator is separated from the phase locked loop except during the times of changing frequency. That arrangement allows the frequency to be changed at a higher speed than with known arrangements because it involves no change in the charge on the loop filter capacitor and the subsequent removal of the digital-analog means that it does not influence the noise characteristics of the voltage controlled oscillator at static state.

The frequency synthesizer of the type is most effective when applied to radio communication systems which switch plural radio channels. Such system is required to search vacant channels at a high speed or switch radio channels without interrupting the communication. By using the frequency synthesizer of this invention as a local oscillator for such radio communication systems, stable locally oscillated frequency may be obtained, and radio channels may be switched at high speed. Moreover, as this allows vacant channel search and non-interrupted channel switching without difficulties, it is highly effective to enhance functions and the performance of the systems.

[Brief Description of the Drawings]

FIG. 1 is a block diagram of a conventional frequency synthesizer.

FIG. 2 is a graph to shown an example of transient behaviors of PLL frequency synthesizer at the time of switching.

FIG. 3 is a block diagram of another conventional frequency synthesizer.

FIG. 4 is a graph to show variation in output frequency of the voltage controlled oscillator in relation to the changes in output voltage from a D/A converter.

FIG. 5 is a graph to show an example of characteris tics of the output frequency in relation to the steering voltage of the voltage controlled oscillator.

FIG. 6 is a graph to show another example of the characteristics of the output frequency in relation to the steering voltage of the voltage controlled oscillator.

FIG. 7 is a block diagram to show the first embodiment of the frequency synthesizer according to this invention.

FIG. 8 is a block diagram to show the second embodiment of the frequency synthesizer according to this invention.

FIG. 9 is a block diagram to show the third embodiment of the frequency synthesizer according to this invention.

FIG. 10 is a block diagram to show the fourth embodiment of the frequency synthesizer according to this invention.

FIG. 11 is a chart to explain timings at frequency switching.

FIG. 12 is a block diagram to show the fifth embodiment of the frequency synthesizer according to this invention.

FIG. 13 is a block diagram to show the sixth embodiment of the frequency synthesizer according to this invention.

FIG. 14 is a view to show an embodiment of the phase detector which has a loop switching function.

FIG. 15 is a block diagram to show an embodiment of the internal construction of a control circuit.

FIG. 16 is a block diagram to show another embodiment of the internal construction of the control circuit.

FIG. 17 is a block diagram to show the seventh embodiment of the frequency synthesizer according to this invention.

FIG. 18 is a circuit diagram to show an embodiment of a variable bandwidth filter.

FIG. 19 is a circuit diagram to show an embodiment of a voltage controlled resistor.

FIG. 20 is a block diagram to show the eighth embodiment of the frequency synthesizer according to this invention.

FIG. 21 is a block diagram to show the ninth embodiment of the frequency synthesizer according to this invention.

FIG. 22 is a block diagram to show the tenth embodiment of the frequency synthesizer according to this invention.

FIG. 23 is a block diagram to show the details of the tenth embodiment.

Fig. 24 is a chart to show timings at frequency switching.

FIG. 25 is a block diagram to show a voltage controlled oscillator and the circuit construction for controlling it.

FIG. 26 is a block diagram to show another voltage controlled oscillator and a circuit construction for controlling it.

FIG. 27 is a graph to show transient behavior of the VCO controlled circuit of FIG. 25 at the time of frequency switching.

FIG. 28 is a block diagram to show the first embodiment of the VCO controlling circuit.

FIG. 29 is a chart to show the waveforms of the output voltage from the D/A converter and the changes in output frequency of the VCO.

FIG. 30 is a circuit diagram to show the construction of the first order low-pass filter.

FIG. 31 is a chart to show transient behavior of the VCO controlling circuit when the first order low-pass filter is used.

FIG. 32 is a view to show the transient behavior when the output from the D/A converter is saturated.

FIG. 33 is a block diagram to show the first embodiment of the VCO controlling circuit.

FIG. 34 is a view to show the frequency switching characteristics in the conventional embodiment shown in FIG. 1.

FIG. 35 is a view to show the frequency switching characteristics in the embodiment shown in FIG. 10.

[Optimal Mode for Embodying This Invention]

FIG. 7 is a block diagram to show the first embodiment of frequency synthesizer according to this invention. The embodiment differs from the prior art shown in FIG. 3 in that the voltage $V_c$ of the capacitor is taken out by an A/D converter 8 and the data thereof is supplied to a control circuit 7. Errors in set voltage which heretofore are caused in the prior art can be avoided by construction mentioned above. For instance, when the steering voltage vs. output frequency characteristics are not linear as shown in the VCO in FIG. 6, the drift compensation voltage $\Delta V_s$ corresponding to the frequency drift $\Delta f_o$ is different between the steering voltages $V_{s1}$ and $V_{s2}$ as indicated in the voltages $\Delta V_{s1}$ and $\Delta V_{s2}$. Therefore, at frequency switching, the frequency drift $\Delta f_o$ is obtained from the values of the drift compensation voltage $\Delta V_{s1}$ in advance, a value of drift compensation voltage $\Delta V_{s2}$ is assumed from the frequency drift $\Delta f_o$ and set the value $V_{s2}$ - ($\Delta V_{s2}$ - $\Delta V_{s1}$ ) at the D/A converter 6.

Under the static state, the drift compensation voltage $\Delta V_{s1}$ becomes equal to the voltage of the capacitor, which is taken out by the A/D converter 8. As the frequency drift $\Delta f_o$ is extremely small, it is obtainable from the VCO gain in the steering voltage $V_{s1}$ and the drift compensating voltage $\Delta V_{s2}$. The voltage drift $\Delta V_{s2}$ may be assumed from the frequency drift $\Delta f_o$ and the VCO gain of the steering voltage $V_{s2}$.

As described above, by setting the output of the D/A converter Vda corresponding to the output frequency $f_{o2}$ as $V_{s2}$ - ($\Delta V_{s2}$ - $\Delta V_{s1}$) and adding the same to an adder 5 at the same time as the division ratio is changed, the frequency can be switched without changing the voltage of the capacitor.

FIG. 15 is a block diagram to show the internal construction of such control circuit 7 wherein a ROM table 17 stores steering voltage vs. VCO output frequency characteristics before the drift shown with solid lines in FIG. 6, inputs desired frequency data, and outputs steering voltage data $V_s$ corresponding thereto. A drift compensation circuit 70 calculates frequency drift $\Delta f_o$ and drift compensation voltage $\Delta V_{s1}$ from the out of the Vda supplied to the D/A converter 6 and the $V_c$ data which is an output from the A/D converter 8, and stores the result, obtains the voltage drift $\Delta V_{s2}$ corresponding to the frequency $f_{o2}$ by referring to the table when the desired frequency data is shifted from $f_{o1}$ to $f_{o2}$, and outputs the drift compensation voltage $\Delta V_s = \Delta V_{s2} - \Delta V_{s1}$ . A subtractor 72 supplies steering voltage $V_{ss} = V_{s2} - (\Delta V_{s2} - \Delta V_{s1})$ to a latch for D/A data 73. ROM table 71 supplies the the voltage $V_{s2}$ corresponding $f_{o2}$. ROM 75 for division ratio receives as input a desired frequency data and supplies division ratio data corresponding thereto a latch for division ratio 74. When switching the desired frequency data from $f_{o1}$ to $f_{o2}$, a timing circuit 76 supplies latch signals respectively to the latch 73 for D/A data and the latch 74 for division ratio after completion of arithmetic operation by the subtractor 72. This renews Vda data and the division ratio data.

Frequency switching time can be shortened by the above operation without making errors in steering voltage even though VCO characteristics are not linear. In FIG. 7 the input of the A/D converter is connected to a terminal or point a of the capacitor in order to take out the capacitor voltage $V_c$, but the same effect may be achieved by taking out the voltage at the points b,c and d from the A/D converter 8 instead of the point a as the electric current does not flow through the resistors $R_1$ and $R_2$ in the static state. However, if the voltage is taken out at the point d, the capacitor voltage $V_c$ is calculated by subtracting the voltage Vda from the value which has been taken out.

In the aforementioned embodiment, a sample hold circuit may be connected to an output of the D/A converter 6 and the steering voltage may be outputted from the sample hold circuit to an adder 4. In this case, power supplying to the D/A converter 6 is stoped after the steering voltage is held at the sample hold circuit. This saves power consumption.

FIG. 8 is a block diagram to show the second embodiment of a frequency synthesizer according to this invention. This embodiment differs from the first embodiment shown in FIG. 7 in that the D/A converter 6 is connected in series to the grounding point of the loop filter 3 to omit the adder. The VCO steering voltage $V_s$ may be expressed similarly to the equation (2) as $V_s = V_c + Vda$ if the voltage of the capacitor is denoted as $V_c$, and the output of the D/A converter as Vda. In this embodiment, $V_c + Vda$ is taken out from the A/D converter 8 and drift compensation voltage $\Delta V_s$ $(=V_c)$ may be obtained by subtracting the voltage Vda from the taken out value. Then, frequency drift $\Delta f_o$ is calculated by the manner similar to the first embodiment, and a D/A converter output data suitable to the output frequency $f_{o2}$ which is to be outputted next is set. The effect similar to the first embodiment can be obtained and the circuit structure may be simplified. As no electric current through the resistors $R_1$ and $R_2$ at the static time, the voltage may be taken out at the point b or c instead of the point a by using the A/D converter 8 to attain the same effect.

FIG. 9 is a block diagram to show the third embodiment frequency synthesizer according to this invention. This embodiment differs from the first embodiment shown in FIG. 7 in that a loop filter 9 includes an operational amplifier in the loop filter 9, and the D/A converter output (Vda) is supplied to a non-inverting input of the operational amplifier which is a signal grounding point of the loop filter 9, and the A/D converter 8 is connected to the output of the loop filter.

The steering voltage $V_s$ of VCO 4 may be expressed as $V_s = V_c + Vda$ similarly to the formula (2) if the voltage of a capacitor is represented as $V_c$ and the output of D/A converter Vda. As no electric current through the resistors $R_1$ and $R_2$ in the static state, $V_c + Vda$ may be obtained from the output from the loop filter. Therefore, the effect similar to the second embodiment shown in FIG. 7 may be obtained by subtracting the voltage Vda from $V_c + Vda$ and calculating $\Delta V_s$ $(= V_c)$.

FIG. 10 is a block diagram to show the fourth embodiment of the frequency synthesizer of this invention. Japanese Patent Application Sho 61-305253 has proposed a method to suppress frequency fluctuation caused by phase errors when PLL is operated intermittently. The operation of the proposed method is applied to reduce the phase errors at the frequency switching herein. This embodiment differs from the first embodiment FIG. 7 in that the reference signal is inputted in the control circuit 7 as a trigger signal and the reset signal is sent to the variable ratio divider 2.

FIG. 11 is a chart to show the timings of frequency switching wherein the loop switch 10 is turned OFF to open the loop at the time $t_1$. The output voltage of the D/A converter 6 is turned from Vda1 to Vda2, and the division ratio is shifted from $N_1$ to $N_2$. The steering voltage of VCO 4 is set at a level corresponding to the target frequency at this stage. The reference signal phase may be different from the phase of the variable ratio divider as shown in FIG. 11. If the loop switch 10 is turned ON as it is, the phase error may cause fluctuation in output frequency. In order to inhibit the fluctuation, a reset signal is sent out to the variable ratio divider 2 at the time $t_3$. The timing for reset signalis determined by triggering the reference signal. This makes the phase of the variable ratio divider locked with the phase of the output from the referencve signal, and if the loop switch 10 is turned ON at the time $t_4$, drifts will not be caused in output frequency due to phase errors. The steering voltage data to be set at the D/A converter 6 is calculatedly by the method similar to the one shown in FIG. 7. This operation can reduce both the steering voltage error and the phase error at the frequency switching .

This chart shows a case where the counting of divider re-start at the end of reset signal which is synchronized with the positive edge of reference signal. The counting of divider may re-start at the end of reset signal which is synchronized with the negative edge of reference signal.

FIG. 16 is a block diagram to show the inside of a control circuit 7 which differs from the structure shown in FIG. 15 by a timing circuit 76. The timing circuit 76 receives the reference signal as a trigger, and outputs the reset signal of the variable ratio divider 2 and the loop switch signal in accordance with the aforementioned timing. These signals are executed in the procedure such as "receiving desired frequency data, turning the loop switch OFF, changing Vda and N, sending reset signal, and turning the loop switch ON".

FIG. 12 is a block diagram of the fifth embodiment of the frequency synthesizer according to this invention. This embodiment is a combination of the embodiment shown in FIG. 8 with a reset function of the variable ratio divider 2. As the combined functions can reduce both the steerieng voltage error and phase errors to zero at frequency switching, the effect similar to the embodiment shown in FIG. 10 may be achieved.

FIG. 13 is a block diagram to show the sixth embodiment of the frequency synthesizer according to this invention. This embodiment is a combination of the embodiment shown in FIG. 9 with a reset function used for the variable ratio divider in the embodiment shown in FIG. 10. This combination enables reduction of both the steering voltage error and phase errors to zero level at frequency switching to achieve the effect similar to the embodiment shown in FIG. 10.

FIG. 14 shows an embodiment of the phase detector having the loop switch function, and more particularly FIG. 14a shows a basic embodiment of the phase detector having the loop switch function which is used in the embodiments shown in FIGs. 10 through 13. FET analog switches which can be switched at high speed may be used as the loop switch shown in the figures. FIG. 14b shows an embodiment which realizes close/open (ON/OFF) of the phase locked loop by combining a charge pump circuit with an FET analog switch and a logic circuit. In this construction, when "0" of the loop ON/OFF signal is inputted, the output from an OR gate 12 becomes "1" despite the logical output from the digital phase detector 1. P channel FET 15 which uses the output from the OR gate 12 input and an N channel FET 16 which uses the output from an AND gate 13 are opened while the phase locked loop is open. When the loop ON/OFF signal "1" is inputted, the gates of both FETs 15 and 16 are driven with the output of the digital phase detector, the phase locked loop is closed. FIG. 14c shows a loop switch which opens the FET when the digital phase detector 1 is reset. FIG. 14d shows that the loop is opened by holding the input of the circuit 1 with OR gates 12a and 12b so that the logical output from the circuit 1 becomes the same state as the phase locked loop to open FETs 15 AND 16.

In the above embodiments, the output from the D/A converter 6 is used as the steering voltage as it is; however, if noises are included within the output from the D/A converter 6, the noise is directly added to the steering voltage. The phase noise in VCO output increases consequently.

The following embodiments attempt to solve the problems. They can prevent phase noise increase which is caused by the addition of the D/A converter. In the description of the following embodiments, the description on the construction to correct non-linearity of the oscillator 4, structure for resetting variable ratio divider and loop switch will be omitted unless specifically required. FIG. 17 is a block diagram to show the seventh embodiment of the frequency synthesizer according to this invention.

The frequency synthesizer comprises a voltage controlled oscillator 4, a variable ratio divider which divides the output from the oscillator 4, a phase detector 1 which compares the phase of the output from the divider 2 with the phase of the reference signal, a loop filter 3 which smoothens the output from the detector 1 and supplies the same to the oscillator 4, and an oscillation frequency switching means which controls oscillation frequency of the oscillator 4 by switching the division ratio of the divider 2. The oscillation frequency switching means includes a control circuit 7, a digital/analog converter 6 which is a voltage supply means which supplies steering voltage corresponding to the frequency after switching to the oscillator 4 when the division ratio of the divider 2 is switched to vary the oscillation frequency at high speed, a variable bandwidth filter 102 which is connected to the output of the digital analog converter 6 and an adder 5 which adds the output of the variable bandwidth filter 102 with the output from the loop filter 3.

Although the frequency synthesizer includes the circuits shown in relation to the first to the sixth embodiments, description is omitted.

This embodiment is characterized in that the voltage supply means includes a variable bandwidth filter 102, and the control circuit 7 includes a bandwidth limiting means which sets the bandwidth of the filter 102 narrower after the frequency swiching.

The variable bandwidth filter 102 connected to the output side of the D/A converter 6 is set to have a narrow bandwidth at the static state, and therefore does not transmit the noises generated in the converter 6 to the voltage controlled oscillator 4. The bandwidth at this time is denoted as $W_2$.

Description will be given to the case where the frequency is switched from $F_1$ to $F_2$ . The frequency is switched by concurrently conducting changing division ratio of the divider 2, changing of input data of the D/A converter 6 and changing of the bandwidth of the filter 102. These changes are controlled by the control circuit 7.

Concurrently to the data change and division ratio change, the bandwidth of the variable bandwidth filter 102 is shifted from $W_2$ to $W_1$ which is wider than $W_2$. By these procedures, the output voltage of the D/A converter 6 is transmitted to the adder 5 at high speed so that the steering voltage of the oscillator 4 is changed to $V_2$ at high speed, thus enabling high speed frequency switching.

After frequency switching, the bandwidth of the filter 102 is reset at $W_2$ again. This enables to suppress the noise generated by the D/A converter 6 and prevent increase in phase noise characteristics in the output of the oscillator 4.

Therefore, without deteriorating noise characteristics of the oscillator 4, the frequency can be switched at high speed.

FIG. 18 shows an embodiment of the variable bandwidth filter. The filter 102 comprises a voltage controlled resistor 103 which changes resistance by the controlling voltage and a capacitor 104.

FIG. 19 shows an embodiment of the voltage controlled resistor 103. The resistor 103 uses a field effect transistor (FET) which changes resistance between source and drain with the voltage applied in the gate. When the resistance is large, the bandwidth becomes narrow, while the resistance is low, the bandwidth becomes wider.

FIG. 20 is a block diagram to show the eighth embodiment of the frequency synthesizer according to this invention.

This embodiment differs from the seventh embodiment in that the output of the variable bandwidth filter 102 is directly connected to the loop filter 3 in order to add the voltages of the filter 102 and of the loop filter 3. However, the operation thereof is identical to that of the seventh embodiment.

FIG. 21 is a block diagram to show the ninth embodiment of the frequency synthesizer accordlng to this invention.

This embodiment differs from the seventh embodiment in that the variable bandwidth filter 102 is connected between the adder 5 and the voltage controlled oscillator 4, but the operation thereof is identical to that of the seventh embodiment. The bandwidth of the filter 102 is varied at frequency switching in this embodiment. This enables high speed frequency switching without deteriorating the noise characteristics of the oscillator 4.

FIG. 22 is a block diagram to show the tenth embodiment of the frequency synthesizer according to this invention.

In this embodiment the D/A converter 6 is connected to a capacitor in the loop filter 3, and a switch 105 is provided between the D/A converter 6 and the capacitor as a means to disconnect the D/A converter 6 after the steering voltage from the converter 6 is holded in the capacitor.

The switch 105 is open by the control circuit 7 in the static state to disconnect the D/A converter 6 from the loop filter 3. The phase locked loop operates ordinarily in this stage, and the VCO output signal with the stability similar to the output signal from the reference oscillator 101 is obtained from the oscillator 4 in the frequency corresponding to the division ratio N set at the variable ratio divider 2.

Description is now given to the case where the frequency $F_1$ is switched to the frequency $F_2$.

Before switching, the voltage V of the capacitor in the loop filter 3 in the static state after switching of the frequency is set at the D/A converter 6. Then, the division ration $N_2$ is set by the control circuit 7 at the divider 2 in correspondence to the frequency F to which the frequency is going to be switched, and at the same time, the switch 105 is closed to apply the output voltage $V_2$ of the digital analog converter 6 to the capacitor in the loop filter 3. This makes the capacitor charged rapidly, and the frequency of the oscillator 4 is rapidly switched to the frequency $F_2$ . Then, the switch 105 is opened after the completion of charging of the capacitor, so as to cut off the output from the converter 6 from the loop filter 3.

The output from the D/A converter 6 is directly connected to the capacitor of the loop filter 3 via the switch 105. If the output impedance of the D/A converter 6 is sufficiently low, the capacitor can be charged at an extremely high speed. As the D/A converter 6 is disconnected from the loop filter 3 after completion of charging, noises generated from the D/A converter 6 is also blocked without influencing the VCO steering voltage. Therefore, the frequency can be switched at a high speed without deteriorating the noise characteristics of the oscillated signals. The switch 105 may be a variable resistor as it is a circuit to disconnect the signal from the D/A converter 6.

FIG. 23 is a block diagram to show the variation of the tenth embodiment. In this embodiment of the frequency synthesizer, similar to the fourth embodiment shown in FIG. 10, the frequency can be switched at a high speed. Moreover, this enables to suppress the noise generated by D/A converter and prevent increase in phase noise characteristics in the output of the oscillator.

The variable ratio divider 2 is a divider with a reset means, and the control circuit 7 resets the divider 2 using the reference signal inputted at the detector as a trigger.

FIG. 24 is a timing chart to show the timing of frequency switching in FIG. 23 wherein all the timings except for that of the signal controlling the switch 105 are the same as those shown in FIG. 11. In this chart, the counting of divider 2 re-start at the end of reset signal which is synchronised with the positive edge of reference signal.

In the seventh to the tenth embodiments, a variable bandwidth filter or a switch is connected to the output of the D/A converter in order to effect both suppression of output noises from the converter and rapid setting of voltages. The construction may be one where the bandwidth of the filter connected to the output of the D/A converter is fixed to achieve a high speed in voltage setting, which will be explained below.

FIGs. 25 and 26 show circuit structures of the voltage controlled oscillator and a circuit for controlling it. VCO control circuit comprises a ROM 201 and a D/A converter 6 in the circuit 7 so that the voltage outputted from the D/A converter 6 is connected either directly (FIG. 25) or via a low-pass filter 202 (FIG. 26).

In the circuit shown in FIG. 25, the ROM 201 receives desired frequency data as an input from outside and supplies frequency control voltage data corresponding to the desired frequency. This makes frequency control voltage supplied to the VCO 4 correspondingly to the desired frequency. The time necessary to switch frequency becomes equal to the voltage settling time of the D/A converter 6, which can be set to the order of micro seconds if a sophisticated D/A converter is used.

However, as the output of the D/A converter 6 contains the noise voltage, the phase-noise characteristic of the output from VCO 4 may deteriorate. As the noise component in the output from the D/A converter 6 is mostly white noises, as shown in FIG. 26, a low-pass filter 202 is connected to the output of the converter 6. This suppresses the phase noise, but the frequency switching time becomes longer.

FIG. 27 shows transient behavior characteristics of the VCO circuit shown in FIG. 25, wherein the frequency is switched from $f_a$ to $f_b$. The voltages $V_a$ and $V_b$ are frequency control voltages respectively corresponding to the frequencies $f_a$, and $f_b$. FIG. 27 shows a case were the output voltage from the D/A converter 6 is switched from $V_a$ to $V_b$ stepwise at the time $t_o$. As illustrated in the figure, when a low-pass filter 202 is inserted, frequency control voltage changes gradually in contrast to the output voltage from the D/A converter 6 which rapidly changes.

In order to eliminate such inconvenience, the bandwidth of the low-pass filter 202 is made variable in the seventh to tenth embodiments. Another approach will be shown below.

FIG. 28 is a block diagram to show the first embodiment of a VCO control circuit. The VCO control circuit comprises a ROM 201, an adding data circuit 203, a digital adder 204, and a D/A converter 6. The output from the D/A converter 6 is supplied to the VCO 4 via the low-pass filter 202.

FIG. 29 shows the changes in the output waveform of the D/A converter 6 and in the output frequency of the VCO 4 when the switching operation starts at the $t_o$ to switch the frequency from $f_a$ to $f_b$. The voltages $V_a$ and $V_b$ are VCO control voltages respectively in correspondence to the frequencies $f_a$ and $f_b$. As shown in the figure, in the VCO control circuit, the input voltage of the low-pass filter 202 (or the output voltage of the D/A converter 6) changes from the initial voltage $V_a$ to the target voltage $V_b$ via the voltages $V_1$ and $V_2$. The frequency switching time may be shortened by controlling the input voltage of the low-pass filter 202 to reach the target voltage via plural voltages. In this embodiment, adding data corresponding to such plural voltages $V_1$ and $V_2$ may be obtained by the arithmetic operation by the circuit 203 shown in FIG. 28. The adding data processed by the circuit 203 are sequentially sent to the digital adding circuit 204. The above operation can control the output voltage of the D/A converter 6 to change from the initial voltage $V_a$ to the target voltage $V_b$ via plural voltages $V_1$ and $V_2$.

The arithmetic operation of adding data at the circuit 13 will not be described. This arithmetic operation is based on the optimal control theory which uses the state-space method. Description will be given first to the low-pass filter of n-th order. As the simplest example, the first order filter is exemplified.

The state equation and the output equation of $\underline{n}$-th order filter are generally expressed as below. ($\underline{n}$ is an integer)

$$\dot{x}(t) = A * x(t) + B * m(t) \qquad (3)$$

$$y(t) = D * y(t) + E * m(t) \qquad (4)$$

wherein

x(t): state vector (column vector comprising state variables in the number of $\underline{n}$)
$\dot{x}$(t): time derivative of state vector
A : system matrix ($\underline{n}$ lines * $\underline{n}$ columns)
m(t): input-vector (column vector comprising input vectors in the number of $\underline{\ell}$)
B : control matrix ($\underline{\ell}$ lines * $\underline{n}$ columns)
y(t): output-vector (column vector comprising output variables in the number of $\underline{p}$)
D : output matrix ($\underline{n}$ lines * $\underline{p}$ columns)
E : direct path matrix ($\underline{\ell}$ lines * $\underline{p}$ columns)

In the case of filters, the input-vector and the output-vector in the above equations (3) and (4) become single variables respectively. Therefore, the input-vector m(t) corresponds to the input voltage $v_i(t)$ of the filter which is expressed as below.

$$m(t) = V_i(t) \qquad (5)$$

The output-vector can be expressed as below because it corresponds to the output voltage $v_o(t)$ .

$$y(t) = v_o(t) \quad (6)$$

Equations (3) and (4) are expressions in time domain, and they will be expressed in s function as below if Laplace-transformed.

$$sX(s) = A * X(s) + B * V_i(s) \quad (7)$$

$$V_o(s) = D * X(s) + E * V_i(s) \quad (8)$$

wherein X(s), $V_i(s)$ and $V_o(s)$ are respectively expressions of x(t), $v_i(t)$ and $v_o(t)$ in s-domain.

The state equations above determine the state transition equation when the sampling time interval is denoted T as below.

$$x((k+1)T) = \Phi(T)\, x(kT) + \Psi(T) v_i(kT) \quad (9)$$

k = 0, 1, 2, 3, 4, ....

wherein Φ and Ψ in the equation (9) are obtained by

$$\Phi = L^{-1} (s\epsilon - A)^{-1} \quad (10)$$

$$\Psi = \int_0^T (T - \tau) * B\, d\tau \quad .....(11)$$

wherein

$L^{-1}$ : inverse-Laplace transformation

$= \epsilon$ : unit matrix.

The input voltage $v_i$ which makes the output voltage of the filter arrive the final target voltage $V_b$ can be obtained as below.

$$v_i(kT) = P_o^T * [\Phi(T)^{-n} * V_b - x(kT)] \quad (12)$$

k = 0, 1, 2, 3, 4, ....

$P_o^T$ in the equation (12) can be obtained as a column vector forming the first line of the matrix P as below

$$R^{-1} = P = \begin{bmatrix} P_0^T \\ P_1^T \\ P_2^T \\ \\ P_i^T \\ \\ P_{n-1}^T \end{bmatrix}$$

$[r_0, r_1, r_2, .....r_{n-1}] = R$

when the matrix is defined with

$\Phi(T) * \Psi(T) = r_0$

$\Phi(T) * \Psi(T) = r_1$

$\Phi(T) * \Psi(T) = r_2$

$\Phi(T) * \Psi(T) = r_{n-1}$

Provided $P_i^T$ is a line vector forming the i-th line of the matrix P.

In order to cause the output voltage of the filter to reach the final target voltage $V_b$ within the minimal time, the input voltage $v_i$ should be changed in accordance with the equation (12). The adding data circuit 203 in FIG. 28 calculates adding data corresponding to $v_i$ according to the equations (9) and (12). The digital adder 204 adds the adding data to the frequency controlled voltage data outputted from the ROM 201 and transmits the result to the D/A converter 6. This generates a voltage corresponding to $v_i$ in the output from the converter 6. As a result, the output voltage of the low-pass filter 202 reaches the voltage $V_b$ within the minimal time, even if the low-pass filter 202 is inserted, and the frequency switching at the VCO 4 can be conducted at high speed.

Description will now be given to the first order low-pass filter which is used as the low-pass filter shown in FIG. 28. FIG. 30 shows a first order low-pass filter comprising a resistor 221 and a capacitor 222. The transfer function G(s) indicating the relation of the input $V_i$ (s) with the output voltage $V_o(s)$ is expressed as below.

$$G(s) = V_o(s)/V_i(s) = \frac{1}{1 + s\tau} \qquad .....(13)$$

wherein $\tau$ represents time constant (CR) determinable by the resistance R of the resistor 21 and the capacitance C of the capacitor 22. As the transfer function is of the first order, the number of state variable may be one. The state variable X is assumed to be $X = V_o$. Therefore, the state equation and the output equation corresponding to the equations (7) and (8) will become as below.

$$sX(s) = -(1/\tau)\, X(s) + (1/\tau)\, V_i(s) \qquad (14)$$

$$V\ (s) = X(s) \qquad (15)$$

They are expressed in time domain as below.

$$\dot{x}(t) = -(1/\tau)\, x(t) + (1/\tau)\, v_i \qquad (16)$$

$$v_o(t) = x(t) \qquad (17)$$

The state transition equation is determined as below from the state equation, the output equation and the equation (9).

$$x((k+1)T) = [\exp(-T/\tau)]\, x(kT) + [1-\exp(-T/\tau)]\, v_i(kT) \qquad (18)$$

k = 0, 1, 2, 3, 4,......

The input voltage $v_i(kT)$ which causes the voltage to reach the target voltage $V_b$ within the minimal time is determined by the equation (12) as below.

$$v_i(kT) = \frac{\exp(-T/\tau)}{1-\exp(-T/\tau)} \left[[\exp(-T/\tau)]\, V_b - x(kT)\right] \qquad .....(19)$$

k = 0, 1, 2, 3, 4,......

Specific numerical values are substituted in the equations (18) and (19). It is assumed that the phase noise in the output of VCO 4 caused by the output noise from the D/A converter 6 is reduced by 20 dB with an offset frequency of 12.5 kHz. If a low-pass filter shown in FIG. 30 Is used, the time constant $\tau$ = C * R should be ca. 0.1 msec. If the low-pass filter of the type is inserted between the D/A converter 6 and the VCO 4, the response characteristics as shown in FIG. 31a are obtained. The graph indicates the characteristics when the output voltage $V_b$ of the low-pass filter 202 is denoted as 0 [V] before switching, and the final output voltage $V_b$ after switching is denoted as 5 [V] while the vertical axis plots the error voltage coresponding to the final voltage $V_b$ of the output voltage of the low-pass filter 202. As illustrated in the graph, the prior art needs switching time of more than 1 msec as the time constant $\tau$ is set at 0.1 msec. According to the equations (18) and (19), the voltage reaches V within one sampling time (0.1 msec) if the input voltage of the low-pass filter is varied with sampling time interval T = 0.1 msec. In order to obtain the output voltage shown in FIG. 31a, the voltage shown in FIG. 31b should be supplied to the input of the low-pass filter 202.

As stated in the foregoing, response time can be shortened by temporarily applying a high voltage on the low-pass filter input immediately after switching.

FIG. 31 shows the case where the input voltage of the low-pass filter 202 is 5 [V] which reaches 8 [V] immediately after switching. The frequency switching time can further be reduced if the sampling time interval T in equations (18) and (19) is further shortened. However, if T is reduced, the voltage immediately after switching increases further, and it would often be difficult to set such a high voltage in practice. Moreover, when unsettable voltage is calculated from the equation (19), as errors are caused in $v_i$ of the equation (18), the state cannot accurately be estimated. This prolongs the response time. Therefore, when the $v_i$ obtained by the equation (19) exceeds 6 [V], the maximum voltages (saturation voltage) which is outputtable from the D/A converter 6 is assumed to be 6 [V], the value of $v_i$ in the equation (18) is substituted with 6 [V]. The response characteristic for the above is expressed in FIGs. 32a and 32b. The output from the D/A converter 6 or the input voltage of the low-pass filter 202 is limited to 6 [V] as shown in FIG. 32b, but the response time can be limited within 2 sampling tImes or less (2 msec) as shown in FIG. 32a.

FIG. 33 is a block diagram to show the second embodiment of VCO control circuit wherein the output data of the ROM 201 is converted from digital to analog by the D/A converter 6 and the output voltage therefrom is inputted at the analog adder 206. The output voltage of the adder voltage generating circuit 205 is supplied to the other input of the analog adder 206. The circuit 205 outputs adding voltage when the desired frequency data is inputted. The effect similar to that of the first embodiment can be obtained with the above construction.

Frequency can be switched at a high speed even if a low-pass filter is inserted in order to suppress the noises in the output from the D/A converter. Accordingly, by incorporating such VCO control circuits within the control circuits shown in FIGs. 15 and 16, a frequency synthesizer which has low noises and which can be switched in frequency at high speed can be realized.

FIGs. 34 and 35 show frequency switching characteristics when the oscillation frequency is switched from 1440 GHz to 1465 GHz. The reference frequency is assumed to be 6.25 kHz. FIG. 34 shows the characteristics obtained by the conventional frequensy synthesizer FIG. 1 while FIG. 35 indicates the characteristics obtained by the embodiment of this invention shown in FIG. 10. While frequency varies across 250 msec after frequency switching in the prior art system, almost no frequency variation occurs in the embodiment of this invention to enable high speed frequency switching less than 1 msec.

**Claims**

**1.** A frequency synthesizer comprising a voltage controlled oscillator (4), a variable ratio divider (2) which operates on the output from the voltage controled oscillator (4), a phase detector (1) which compares the output phase of the variable ratio divider (4) with the phase of a reference signal, a loop filter (3) which smooths the output of the phase detector (1) and supplies it to the voltage controlled oscillator (4) and an oscillation frequency switching means (7) which changes the oscillation frequency of the voltage controlled oscillator (4) by changing the division ratio of the variable ratio divider (2), wherein the oscillation frequency switching means (7) includes a voltage supply means which supplies a frequency-setting steering voltage to the voltage controlled oscillator (4) via a D/A converter (6) in synchronization with the change of the division ratio of the variable ratio divider (2), characterized in that the variable ratio divider (2) has a reset means, and the oscillation frequency switching (7) means includes a means which resets the variable ratio divider (2) by using the reference signal at the phase detector (1) as a trigger.

**2.** A frequency synthesizer as claimed in claim 1, wherein a loop switch (105) is provided at an input of the loop filter (3), and the oscillation frequency switching means (7) includes a means which opens the loop switch (105) before switching the oscillation frequency and closes the loop switch (105) after the variable ratio divider (2) is reset.

3. A frequency synthesizer as claimed in claim 1 or claim 2, wherein a sample-hold circuit is connected to an output of the D/A converter (6) and the synthesizer is provided with a means which stops the supply of power to the D/A converter (6) after a sample of the steering voltage is held at the sample-hold circuit.

4. A frequency synthesizer as claimed in claim 3, wherein the sample-hold circuit includes a capacitor (19) that is a component element of the loop filter (3).

5. A frequency synthesizer as claimed in any one of claims 1 to 4, wherein a variable bandwidth filter (102) is connected to an output of the D/A converter (6), and the oscillation frequency switching means (7) includes a bandwidth limiting means which reduces the bandwidth of the variable bandwidth filter (102) after the change of the oscillation frequency.

6. A frequency synthesizer as claimed in any one of claims 1 to 4, wherein a variable bandwidth filter (102) is connected to an input of the voltage controlled oscillator (4), and the oscillation frequency switching means (7) includes a bandwidth limiting means which reduces the bandwidth of the variable bandwidth filter after the change of the oscillation frequency.

7. A frequency synthesizer as claimed in any one of claims 1 to 6, wherein a low-pass filter (202) is connected to an output of the D/A converter (6), and the voltage supply means includes a means which causes the D/A convertor (6) to provide a plurality of voltages alternating above and below the steering voltage corresponding to the required frequency, in advance of providing the steering voltage corresponding to the required frequency.

8. A frequency synthesizer as claimed in any one of claims 1 to 7, wherein the voltage controlled oscillator (4) has an oscillation frequency corresponding non-linearly to the input steering voltage, a voltage measuring means is provided for measuring the voltage supplied from the loop filter (3) to the voltage controlled oscillator (4), and the voltage supply means includes a steering voltage compensation means which applies a correction to the steering voltage supplied to the voltage controlled oscillator (4), when its frequency is changed, in order to compensate for the non-linearity of the voltage controlled oscillator (4), the correction to the steering voltage being based on the value measured by the voltage measuring means before the change in frequency.

9. A frequency synthesizer as claimed in claim 8, wherein the steering voltage compensation means generates a voltage equal to $[V_{S2} - (\Delta V_{S2} - \Delta V_{S1})]$ when the oscillator frequency is $f_2$, where $\Delta V_{S1}$ represents the voltage obtained by the voltage measuring means, when the oscillator frequency is $f_1$, $V_{S2}$ represents the frequency-setting, steering voltage required to generate the frequency $f_2$ without drift compensation, and $\Delta V_{S2}$ represents the voltage required to compensate for the drift of the oscillator at the frequency $f_2$, where $f_2 > f_1$.

**Patentansprüche**

1. Ein Frequenzsynthesegerät, umfassend einen spannungsgesteuerten Oszillator (4), einen Teiler (2) variablen Teilungsverhältnisses, der auf den Ausgang von dem spannungsgesteuerten Oszillator (4) einwirkt, einen Phasendetektor (1), der die Ausgangsphase des Teilers (4) variablen Teilungsverhältnisses mit der Phase eines Referenzsignals vergleicht, ein Schleifenfilter (3), das den Ausgang des Phasendetektors (1) glättet und ihn dem spannungsgesteuerten Oszillator (4) zuführt, und ein Schwingfrequenzumschaltmittel (7), das die Schwingfrequenz des spannungsgesteuerten Oszillators (4) ändert durch Änderung des Teilungsverhältnisses des Teilers variablen Teilungsverhältnisses (2), wobei das Schwingfrequenzumschaltmittel (7) ein Spannungszufuhrmittel umfaßt, das eine frequenzeinstellende Steuerspannung dem spannungsgesteuerten Oszillator (4) über einen D/A-Wandler (6) synchron mit der Änderung des Teilungsverhältnisses des Teilers (2) variablen Teilungsverhältnisses zuführt, dadurch gekennzeichnet, daß der Teiler (2) variablen Teilungsverhältnisses ein Rücksetzmittel aufweist, und das Schwingfrequenzumschaltmittel (7) ein Mittel enthält, das den Teiler (2) variablen Teilungsverhältnisses umschaltet unter Verwendung des Referenzsignals zu dem Phasendetektor (1) als ein Trigger.

2. Ein Frequenzsynthesegerät nach Anspruch 1, bei dem ein Schleifenschalter (105) an einem Eingang des Schleifenfilters (3) vorgesehen ist, und das Schwingfrequenzumschaltmittel (7) ein Mittel umfaßt, das den Schleifenschalter (105) öffnet, bevor die Schwingfrequenz geschaltet wird, und den Schleifenschalter (105) schließt, nachdem der Teiler (2) variablen Teilungsverhältnisses rückgesetzt ist.

**3.** Ein Frequenzsynthesegerät nach Anspruch 1 oder Anspruch 2, bei dem eine Abtast- und Halteschaltung an einen Ausgang des D/A-Wandlers (6) angeschlossen ist, und das Synthesegerät mit einem Mittel versehen ist, das die Zufuhr von Leistung zu dem D/A-Wandler (6) abstoppt, nachdem ein Abtastwert der Steuerspannung in der Abtast- und Halteschaltung gehalten ist.

**4.** Ein Frequenzsynthesegerät nach Anspruch 3, bei dem die Abtast- und Halteschaltung einen Kondensator (19) umfaßt, der ein Komponentenelement des Schleifenfilters (3) ist.

**5.** Ein Frequenzsynthesegerät nach einem der Ansprüche 1 bis 4, bei dem ein Filter (102) variabler Bandbreite mit einem Ausgang des D/A-Wandlers (6) verbunden ist, und bei dem das Schwingfrequenzumschaltmittel (7) ein Bandbreitebegrenzungsmittel umfaßt, das die Bandbreite des Filters (102) variabler Bandbreite nach der Änderung der Schwingfrequenz herabsetzt.

**6.** Ein Frequenzsynthesegerät nach einem der Ansprüche 1 bis 4, bei dem ein Filter (102) variabler Bandbreite mit einem Eingang des spannungsgesteuerten Oszillators (4) verbunden ist, und das Schwingfrequenzumschaltmittel (7) ein Bandbreitebegrenzungsmittel umfaßt, das die Bandbreite des Filters variabler Bandbreite herabsetzt nach Änderung der Schwingfrequenz.

**7.** Ein Frequenzsynthesegerät nach einem der Ansprüche 1 bis 6, bei dem ein Tiefpassfilter (202) mit einem Ausgang des D/A-Wandlers (6) verbunden ist, und bei dem das Spannungsversorgungsmittel ein Mittel umfaßt, das den D/A-Wandler (6) veranlaßt, eine Mehrzahl von Spannungen zu erzeugen, die über und unter der Steuerspannung, welche der gewünschten Frequenz entspricht, alternieren, bevor die Steuerspannung entsprechend der gewünschten Frequenz bereitgestellt wird.

**8.** Ein Frequenzsynthesegerät nach einem der Ansprüche 1 bis 7, bei dem der spannungsgesteuerte Oszillator (4) eine Schwingfrequenz hat, welche nichtlinear der Eingangssteuerspannung entspricht, bei dem ein Spannungsmeßmittel vorgesehen ist für das Messen der von dem Schleifenfilter (3) gelieferten Spannung an den spannungsgesteuerten Oszillator (4), und bei dem das Spannungszufuhrmittel ein Steuerspannungskompensationsmittel umfaßt, das eine Korrektur an der dem spannungsgesteuerten Oszillator (4) zugeführten Steuerspannung vornimmt, wenn seine Frequenz geändert wird, um bezüglich der Nichtlinearität des spannungsgesteuerten Oszillators (4) eine Kompensation vorzunehmen, wobei die Korrektur an der Steuerspannung auf dem Wert basiert, der von dem Spannungsmeßmittel vor der Frequenzänderung gemessen wurde.

**9.** Ein Frequenzsynthesegerät nach Anspruch 8, bei dem das Steuerspannungskompensationsmittel eine Spannung erzeugt, die gleich ist [ $V_{S2}$ - ($\Delta V_{S2}$ - $\Delta V_{S1}$)], wenn die Oszillatorfrequenz $f_2$ ist, wobei $\Delta V_{S1}$ die Spannung repräsentiert, die durch das Spannungsmeßmittel erhalten wird, wenn die Oszillatorfrequenz $f_1$ ist, $V_{S2}$ die frequenzeinstellende Steuerspannung repräsentiert, die erforderlich ist, um die Frequenz $f_2$ ohne Driftkompensation zu erzeugen, und $\Delta V_{S2}$ die Spannung repräsentiert, die erforderlich ist, um eine Kompensation bezüglich der Drift des Oszillators bei der Frequenz $f_2$ vorzunehmen, wobei $f_2 > f_1$ ist.

## Revendications

**1.** Un synthétiseur de fréquence comprenant un oscillateur commandé par tension (4), un diviseur de rapport variable (2) agissant sur la sortie de l'oscillateur commandé par tension (4), un détecteur de phase (1) qui compare la phase de sortie du diviseur de rapport variable (4) à la phase d'un signal de référence, un filtre de boucle (3) qui lisse la sortie du détecteur de phase (1) et l'envoie à l'oscillateur commandé par tension (4) et des moyens de commutation de fréquence d'oscillation (7) qui modifient la fréquence d'oscillation de l'oscillateur commandé par tension (4) en modifiant le rapport de division du diviseur à rapport variable (2), dans lequel les moyens de commutation de fréquence d'oscillation (7) comprennent des moyens d'alimentation de tension qui envoient une tension de commande de réglage de tension à l'oscillateur commandé par tension (4) par l'intermédiaire d'un convertisseur numérique/analogique (6) en synchronisme avec la modification du rapport de division du diviseur à rapport variable (2), caractérisé en ce que le diviseur à rapport variable (2) comprend des moyens de remise à zéro et que les moyens de commutation de fréquence d'oscillation (7) comprennent des moyens qui remettent à zéro le diviseur à rapport variable (2) en utilisant comme moyens de déclenchement le signal de référence envoyé au détecteur de phase (1).

**2.** Un synthétiseur de fréquence selon la revendication 1, dans lequel il est prévu un commutateur de boucle (105) à une entrée du filtre de boucle (3), et les moyens de commutation de fréquence d'oscillation (7) comprennent des moyens qui ouvrent le commutateur de boucle (105) avant la commutation de la fréquence d'oscillation et ferment le commutateur de boucle (105) après la remise à zéro du diviseur à rapport variable (2).

**3.** Un synthétiseur de fréquence selon la revendication 1 ou 2, dans lequel un circuit de maintien d'échantillon est relié à une sortie du convertisseur numérique/analogique (6) et le synthétiseur est pourvu de moyens interrupant l'alimentation en énergie du convertisseur numérique/analogique (6) après le maintien d'un échantillon de la tension de commande dans le circuit de maintien d'échantillon.

**4.** Un synthétiseur de fréquence selon la revendication 3, dans lequel le circuit de maintien d'échantillon comprend un condensateur (19) constituant un élément du filtre de boucle (3).

**5.** Un synthétiseur de fréquence selon l'une quelconque des revendications 1 à 4, dans lequel un filtre à largeur de bande variable (102) est relié à une sortie du convertisseur numérique/analogique (6), et les moyens de commutation de fréquence d'oscillation (7) comprennent des moyens de limitation de largeur de bande qui réduisent la largeur de bande du filtre à largeur de bande variable (102) après la modification de la fréquence d'oscillation.

**6.** Un synthétiseur de fréquence selon l'une quelconque des revendications 1 à 4, dans lequel un filtre à largeur de bande variable (102) est relié à une entrée de l'oscillateur commandé par tension (4) et les moyens de commutation de fréquence d'oscillation (7) comprennent des moyens de limitation de largeur de bande qui réduisent la largeur de bande du filtre à largeur de bande variable après la modification de la fréquence d'oscillation.

**7.** Un synthétiseur de fréquence selon l'une quelconque des revendications 1 à 6, dans lequel un filtre passe-bas (202) est relié à une sortie du convertisseur numérique/analogique (6), et les moyens d'alimentation de tension comprennent des moyens qui provoquent l'émission par le convertisseur numérique/analogique (6) d'une pluralité de tensions alternativement au dessus et au dessous de la tension de commande correspondant à la fréquence requise, avant d'émettre la tension de commande correspondant à la fréquence requise.

**8.** Un synthétiseur de fréquence selon l'une quelconque des revendications 1 à 7, dans lequel l'oscillateur commandé par tension (4) a une fréquence d'oscillation correspondant non-linéairement à la tension de commande d'entrée, des moyens de mesure de tension sont prévus pour mesurer la tension émise par le filtre de boucle (3) vers l'oscillateur commandé par tension (4), et les moyens d'alimentation de tension comprennent des moyens de compensation de tension de commande qui appliquent une correction à la tension de commande envoyée à l'oscillateur commandé par tension (4) quand sa fréquence est modifiée, afin de compenser la non-linéarité de l'oscillateur commandé par tension (4), la correction de la tension de commande étant basée sur la valeur mesurée par les moyens de mesure de tension avant la modification de la fréquence.

**9.** Un synthétiseur de fréquence selon la revendication 8, dans lequel les moyens de compensation de tension de commande émettent une tension égale à $[V_{S2} - (\Delta V_{S2} - \Delta V_{S1})]$ lorsque la fréquence de l'oscillateur est $f_2$, où $\Delta V_{S1}$ représente la tension obtenue par les moyens de mesure de tension lorsque la fréquence de l'oscillateur est $f_1$, $V_{S2}$ représente la tension de commande à réglage de fréquence requise pour émettre la fréquence $f_2$ sans compensation de dérive, et $\Delta V_{S2}$ représente la tension requise pour compenser la dérive de l'oscillateur à la fréquence $f_2$, lorsque $f_2 > f_1$.

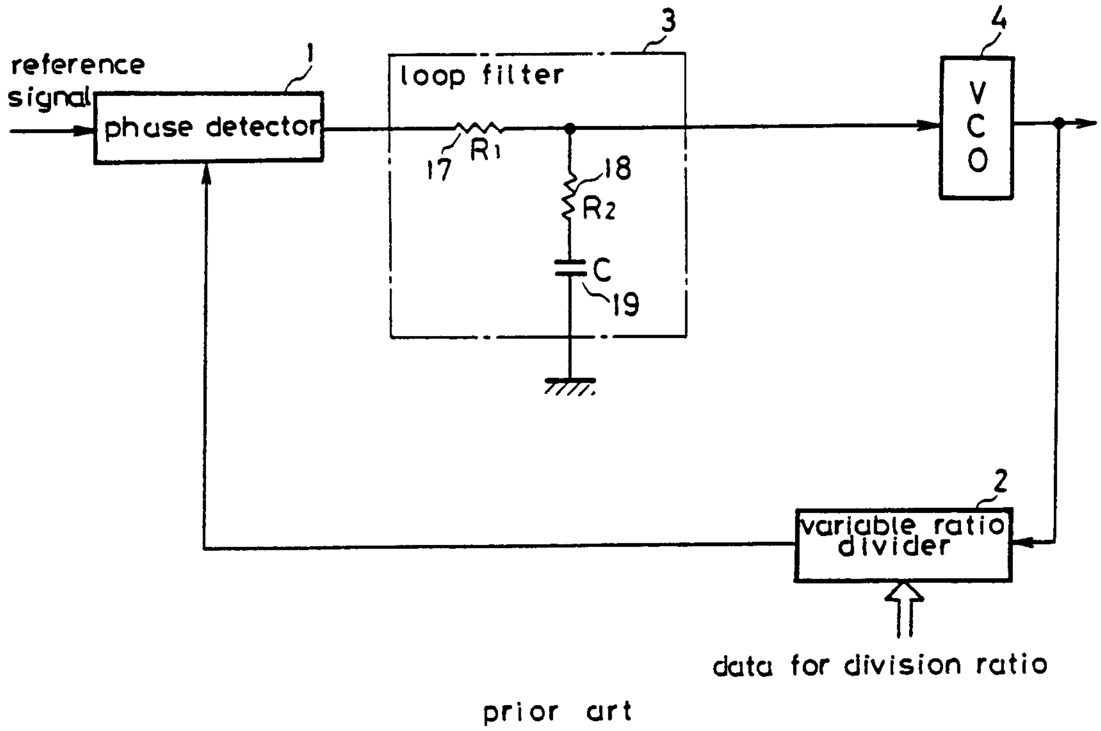
reference signal
phase detector
1
loop filter
3
R1
17
18
R2
C
19
V C O
4
variable ratio divider
2
data for division ratio
prior art

FIG. 1

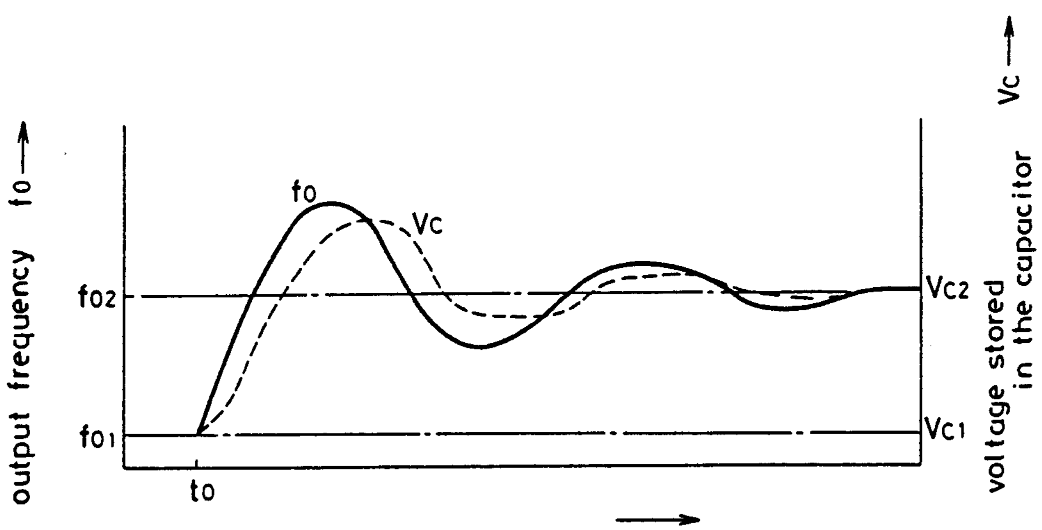
output frequency fo
fo2
fo1
to
fo
Vc
Vc2
Vc1
voltage stored in the capacitor
Vc

FIG. 2

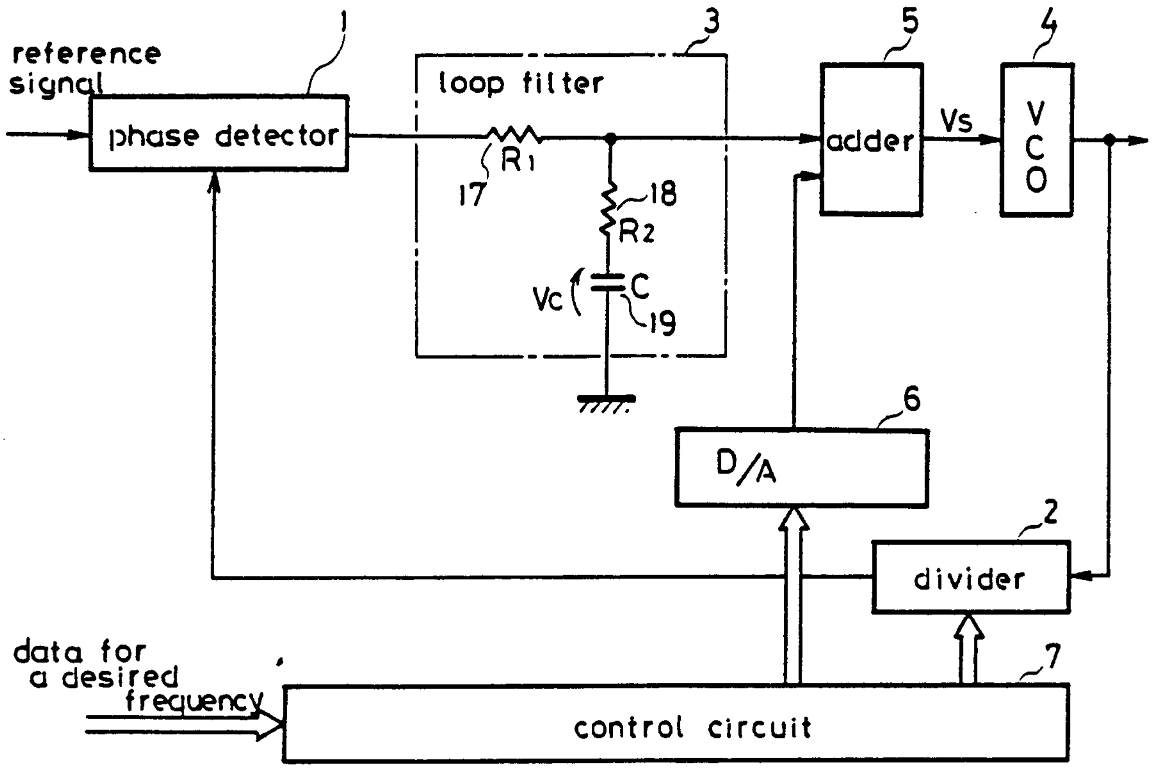


prior art

FIG. 3

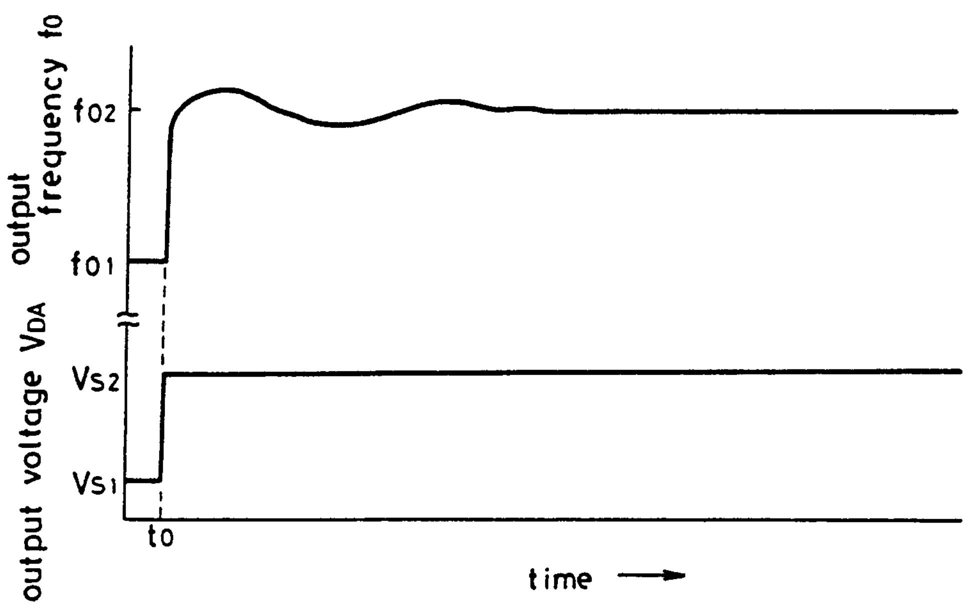


FIG. 4

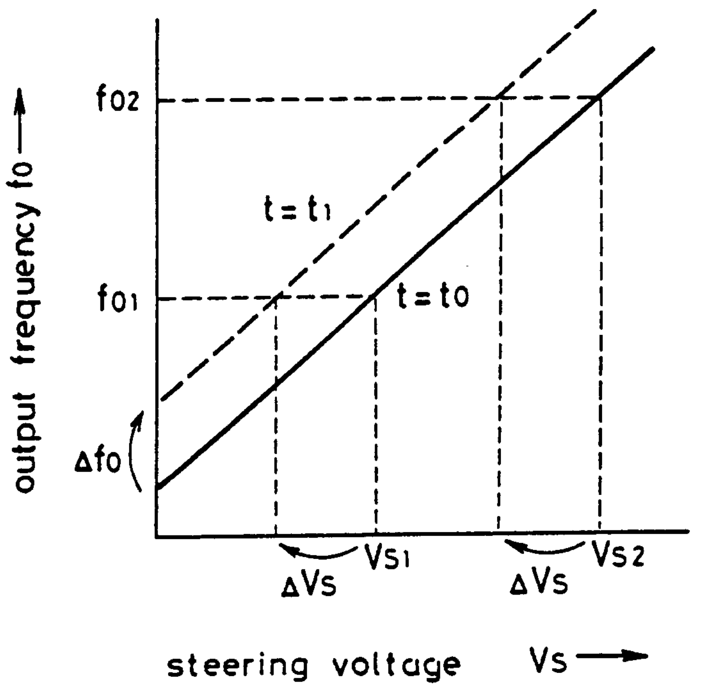
f02
f01
t=t1
t=t0
Δf0
output frequency f0
Vs1
Vs2
ΔVs
ΔVs
steering voltage Vs

FIG. 5

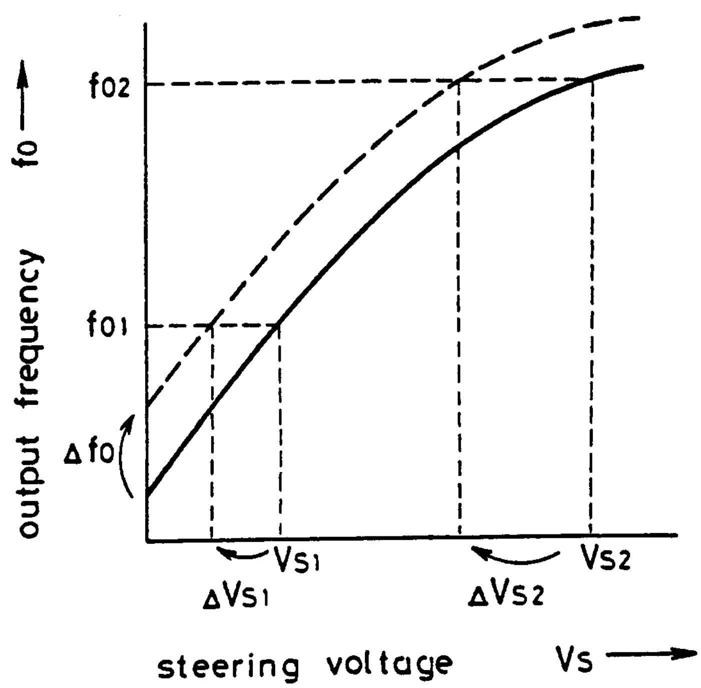
f02
f01
Δf0
output frequency f0
Vs1
Vs2
ΔVs1
ΔVs2
steering voltage Vs

FIG. 6

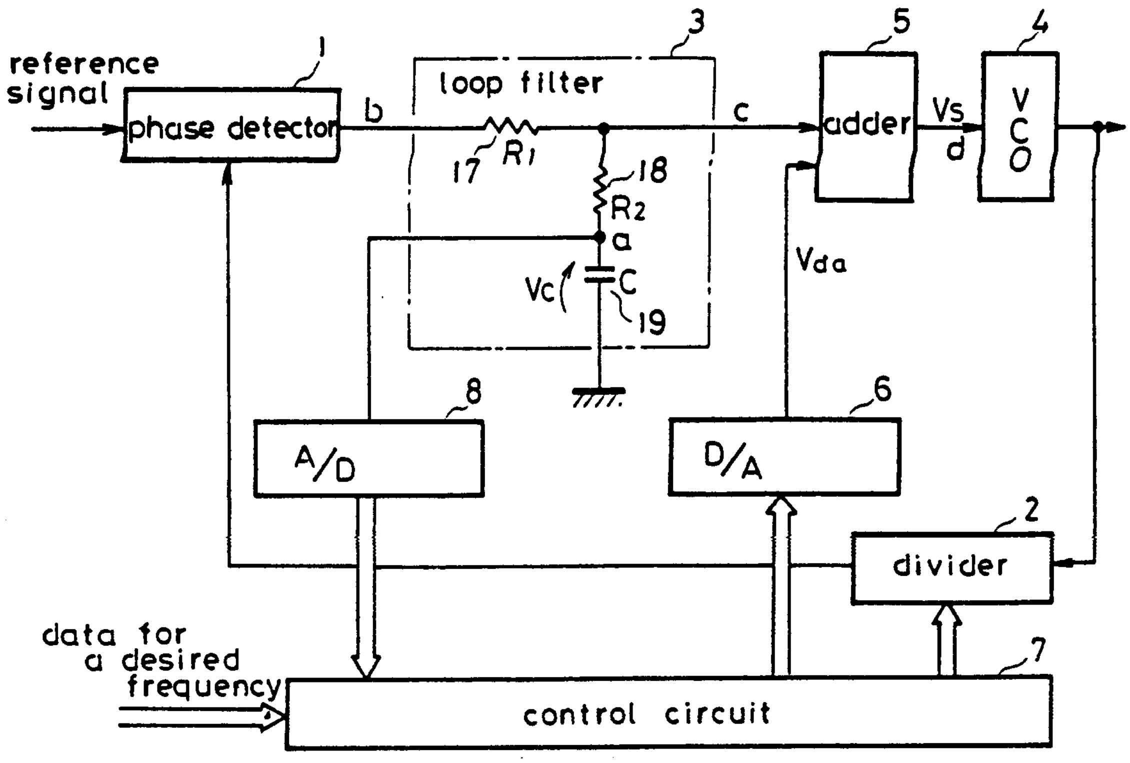
reference signal
1
phase detector
b
3
loop filter
17
R1
18
R2
a
Vc
C
19
c
5
adder
Vs
d
4
VCO
Vda
8
A/D
6
D/A
2
divider
data for a desired frequency
7
control circuit

FIG. 7

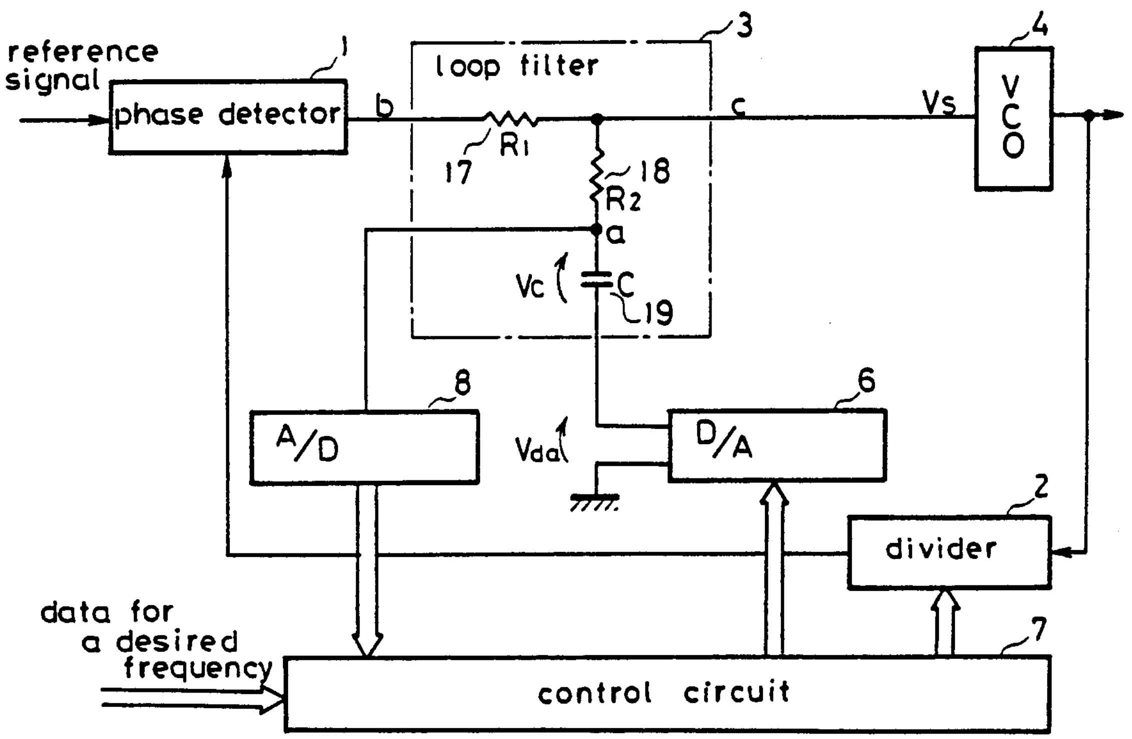
reference signal
1
phase detector
b
3
loop filter
17
R1
18
R2
a
Vc
C
19
c
Vs
4
VCO
8
A/D
Vda
6
D/A
2
divider
data for a desired frequency
7
control circuit

FIG. 8

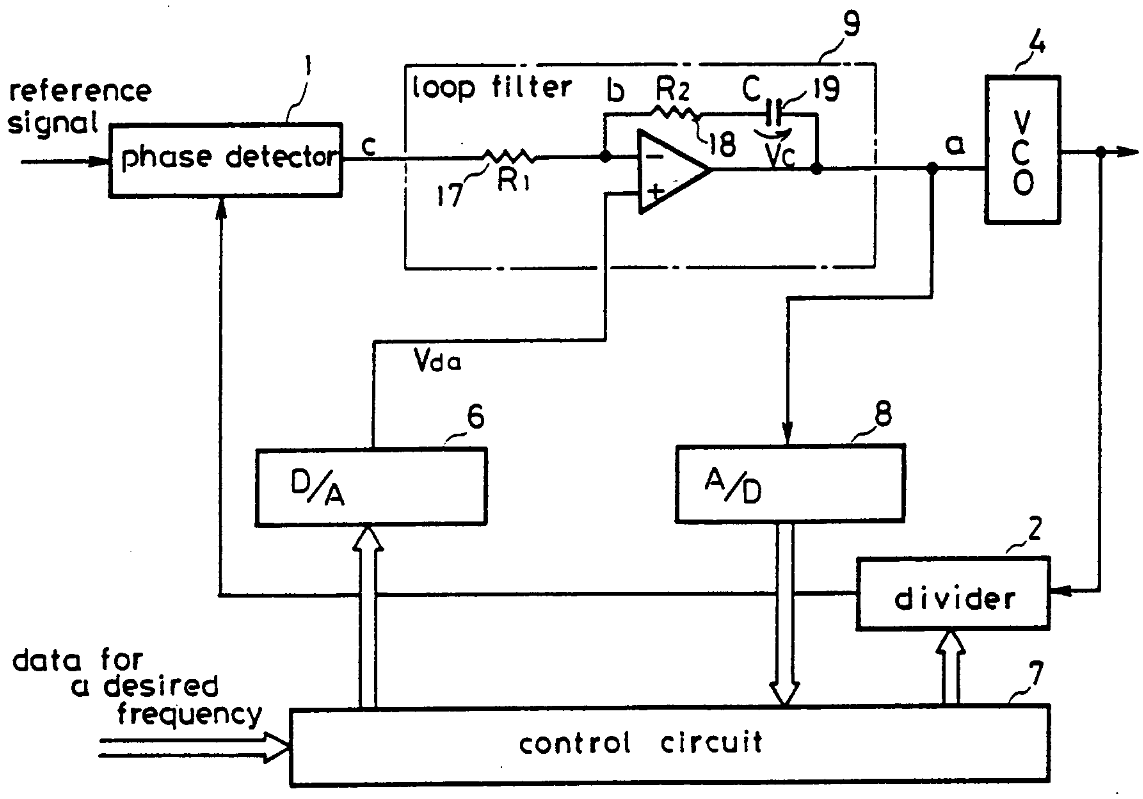
reference signal
phase detector
1
c
loop filter
9
b
R2
C
19
18
Vc
17
R1
a
4
VCO
Vda
6
D/A
8
A/D
2
divider
data for a desired frequency
7
control circuit

FIG. 9

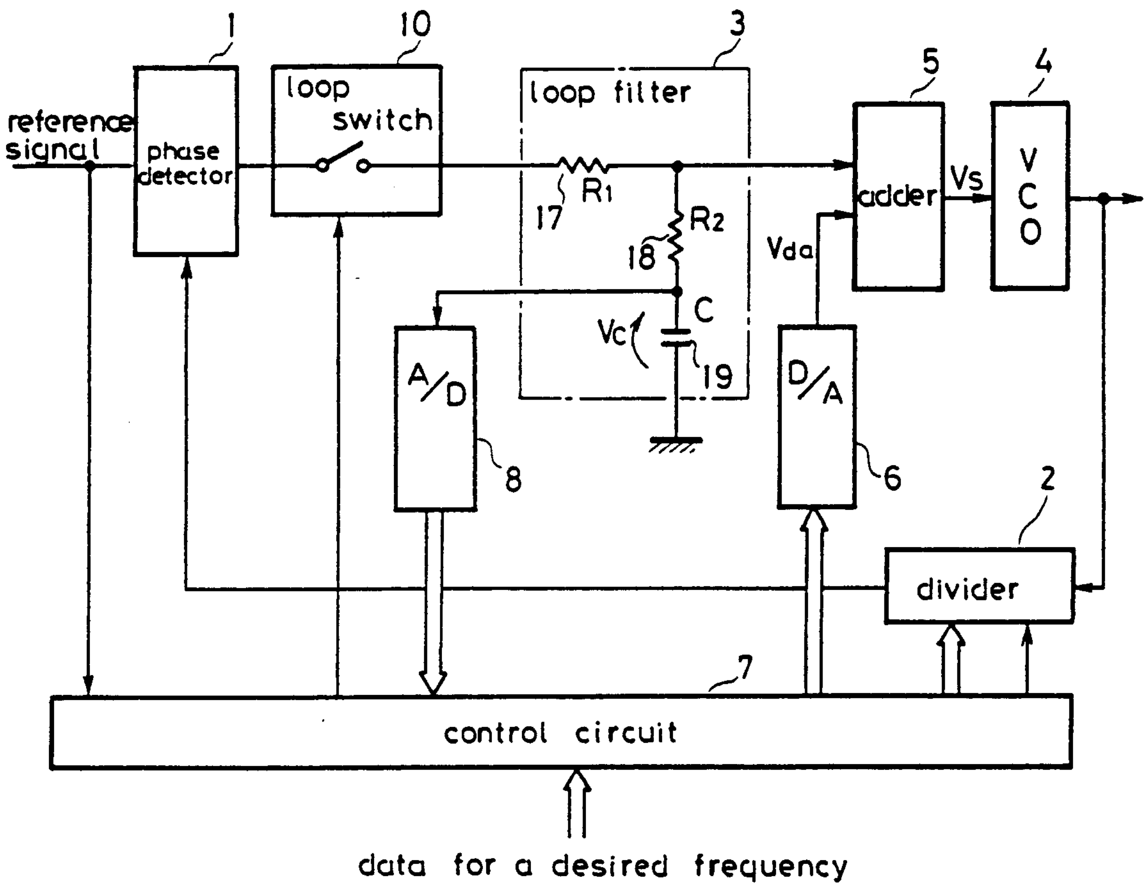
reference signal
phase detector
1
loop switch
10
loop filter
3
R1
17
R2
18
C
Vc
19
adder
5
Vs
VCO
4
Vda
A/D
8
D/A
6
divider
2
control circuit
7
data for a desired frequency

FIG. 10

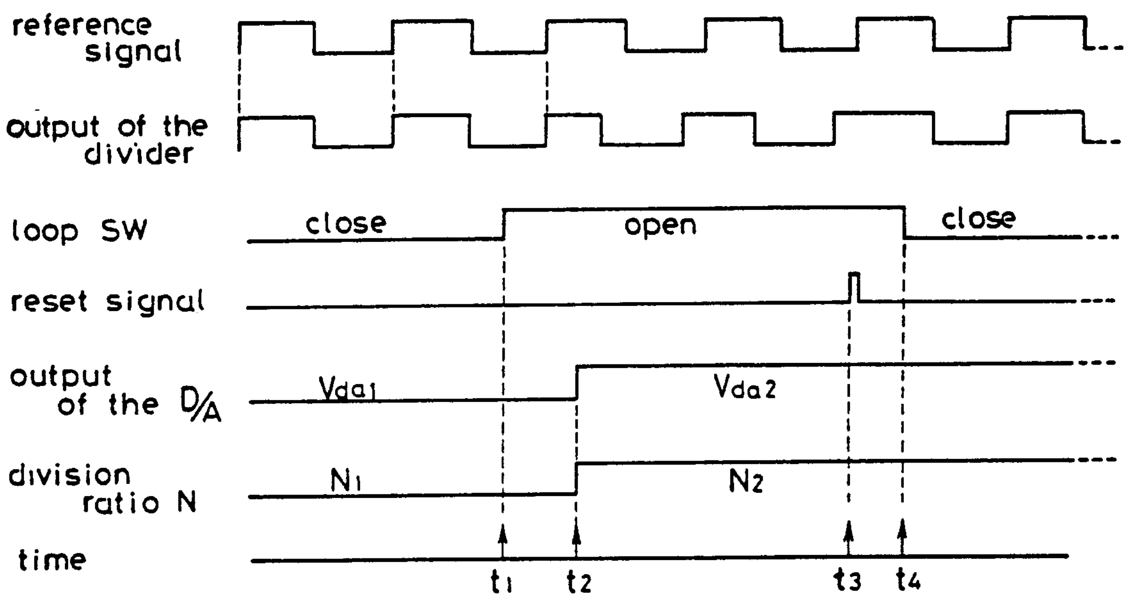
reference signal
output of the divider
loop SW
close
open
close
reset signal
output of the D/A
Vda1
Vda2
division ratio N
N1
N2
time
t1
t2
t3
t4

FIG. 11

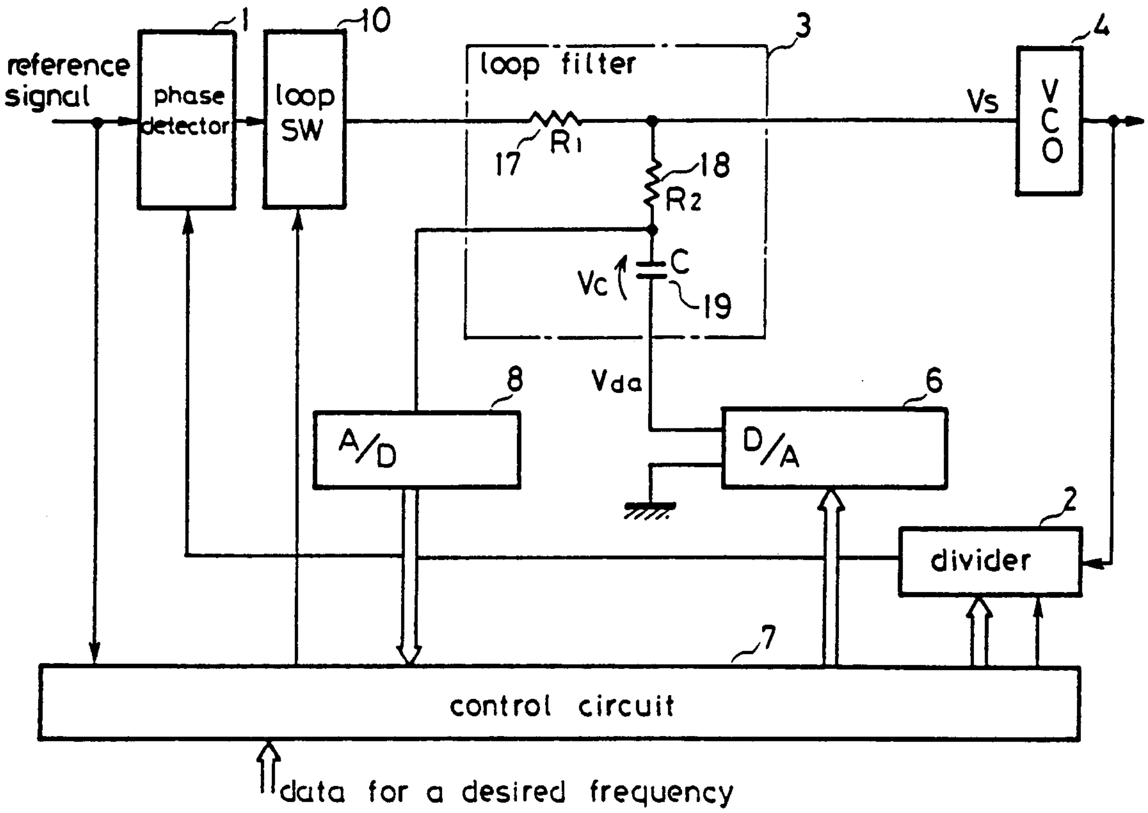
reference signal
phase detector
1
loop SW
10
loop filter
3
R1
17
18
R2
C
Vc
19
Vs
VCO
4
A/D
8
Vda
D/A
6
divider
2
7
control circuit
data for a desired frequency

FIG. 12

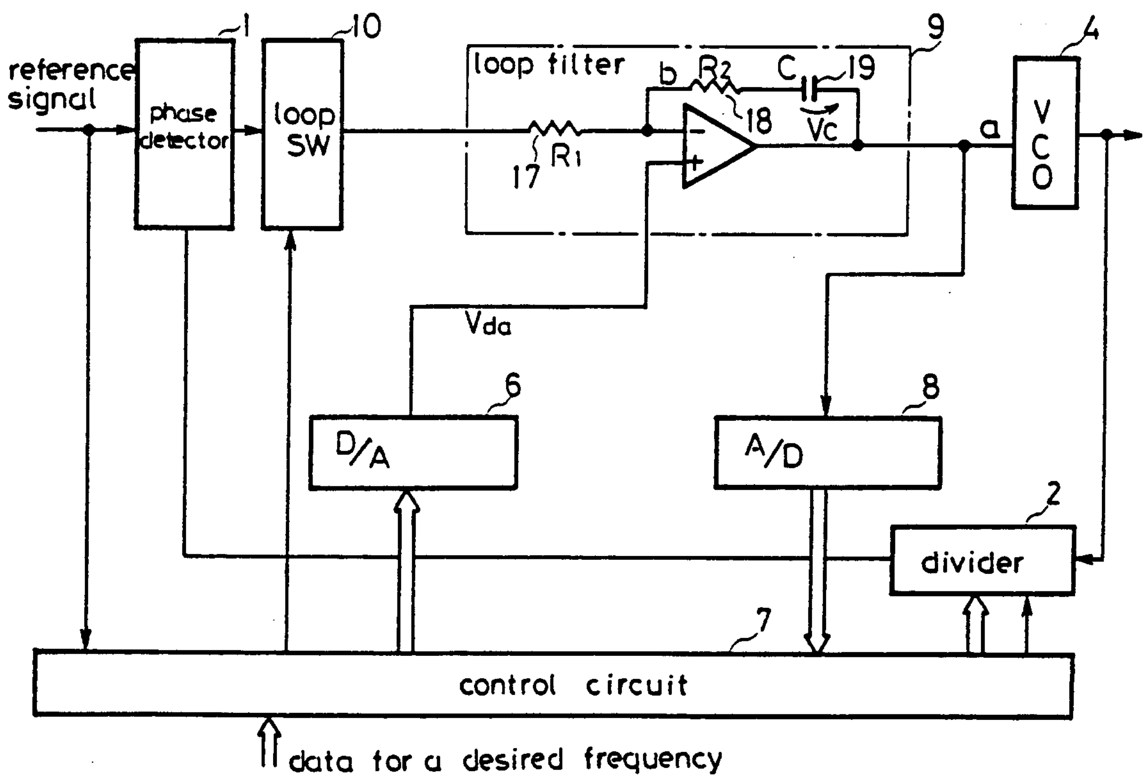
reference signal
phase detector
1
loop SW
10
loop filter
9
b
R2
C
19
18
Vc
R1
17
a
VCO
4
Vda
D/A
6
A/D
8
divider
2
7
control circuit
data for a desired frequency

FIG. 13

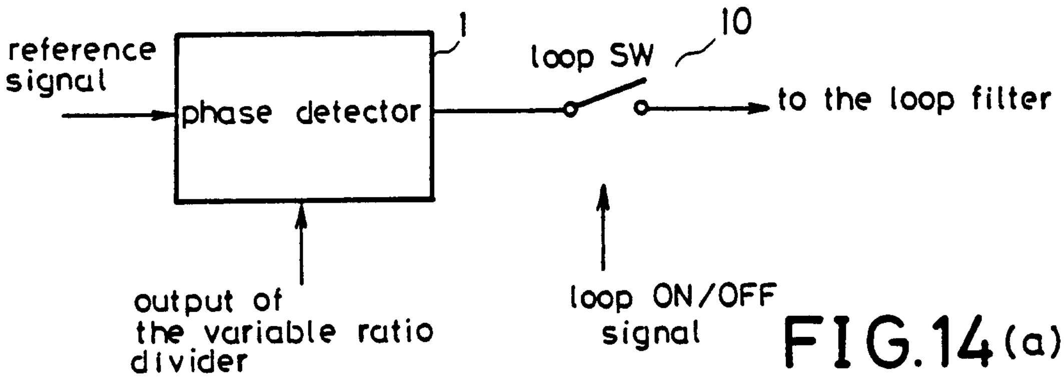


FIG.14(a)

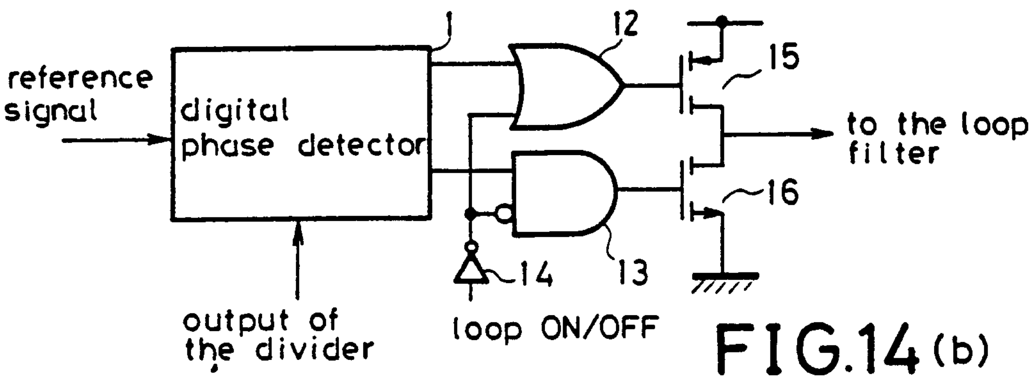


FIG.14(b)

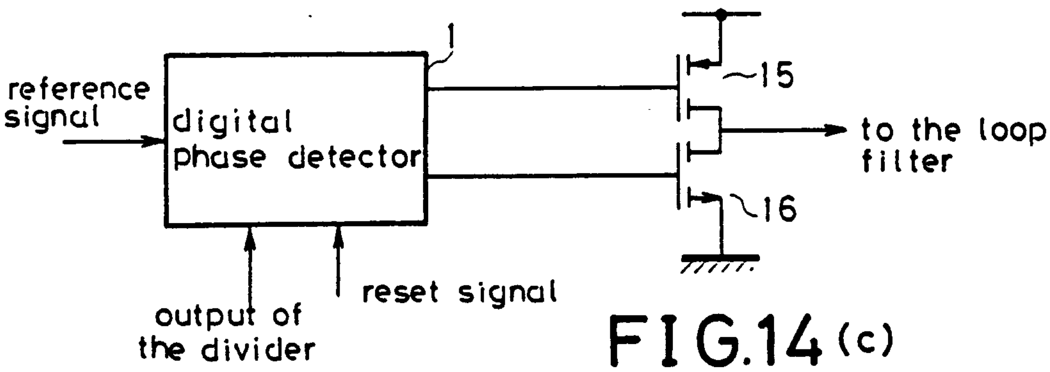


FIG.14(c)

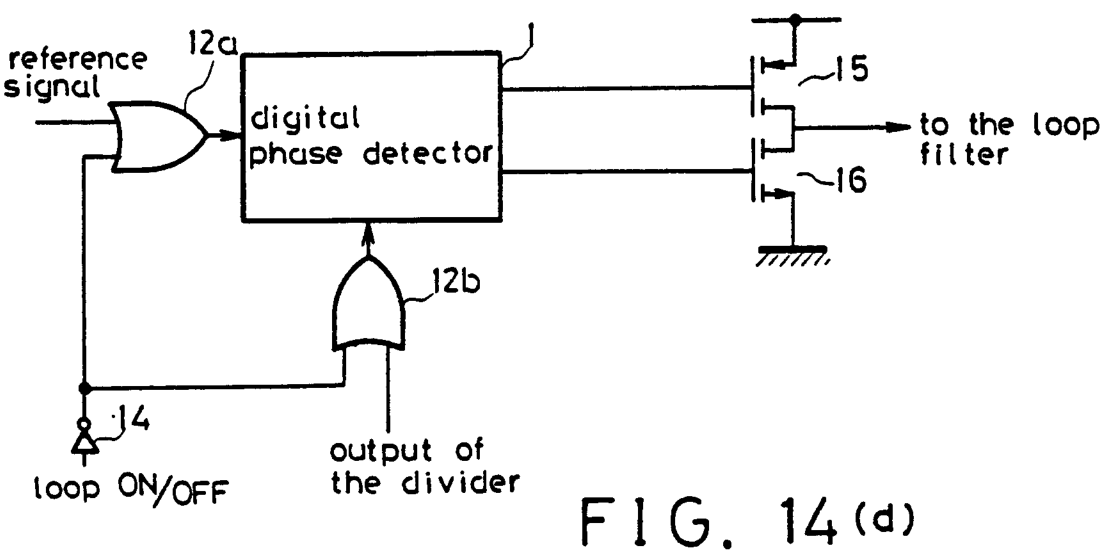


FIG. 14(d)

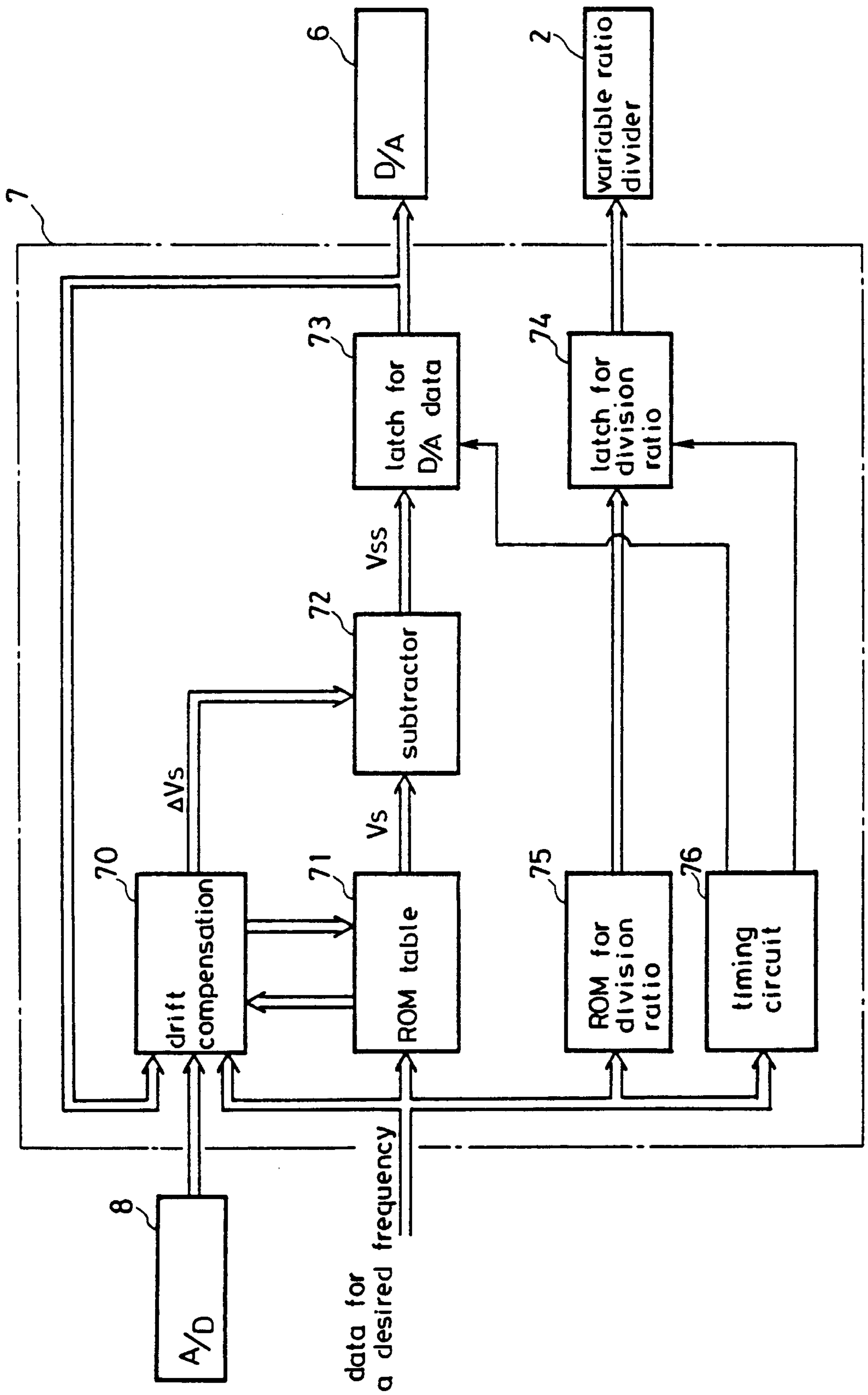
6
D/A
2
variable ratio divider
7
73
latch for D/A data
74
latch for division ratio
72
subtractor
Vss
ΔVs
Vs
70
drift compensation
71
ROM table
75
ROM for division ratio
76
timing circuit
8
A/D
data for a desired frequency

FIG. 15

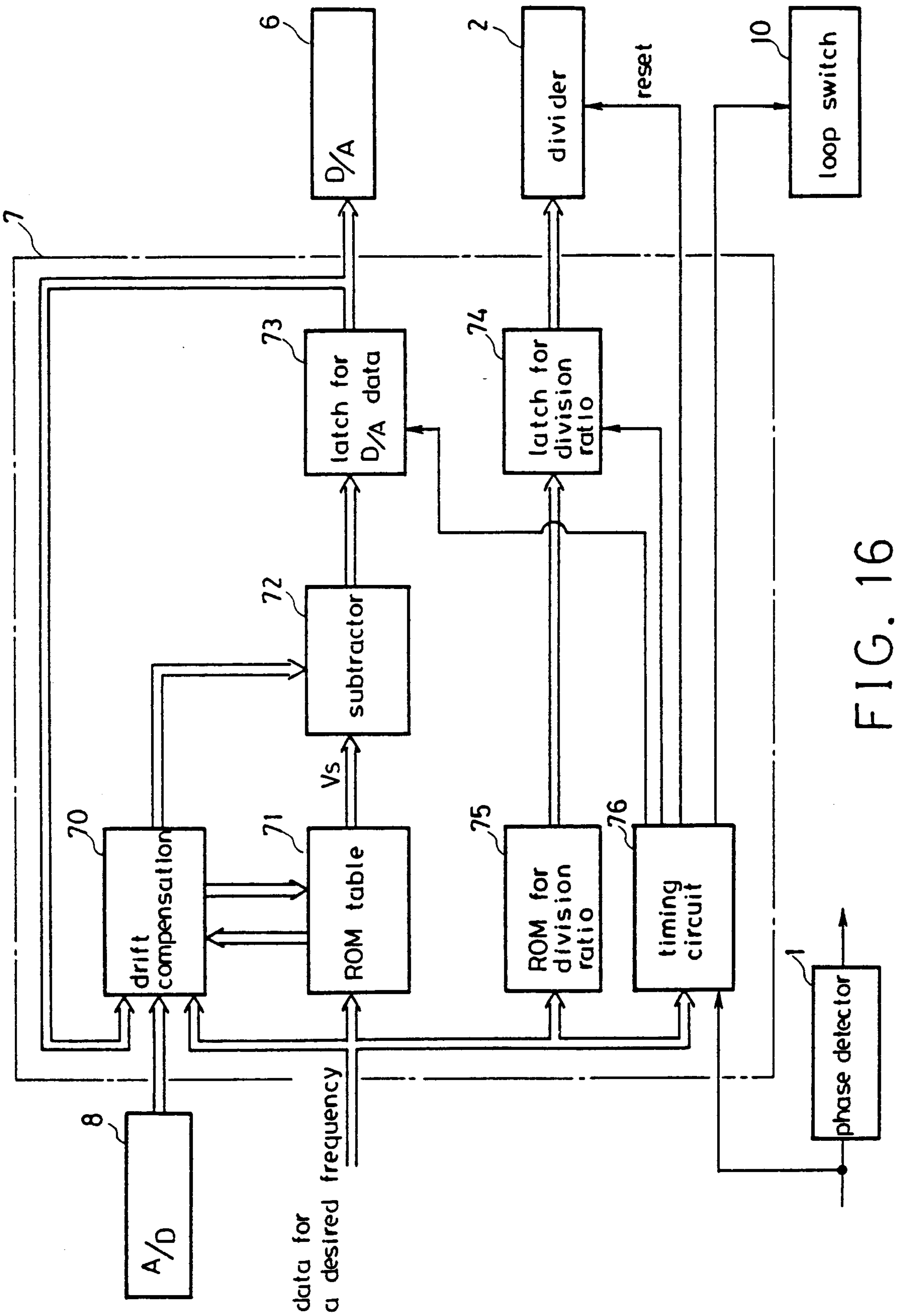

6
D/A
2
divider
reset
10
loop switch
7
73
latch for D/A data
74
latch for division ratio
72
subtractor
Vs
70
drift compensation
71
ROM table
75
ROM for division ratio
76
timing circuit
1
phase detector
8
A/D
data for a desired frequency


FIG. 16

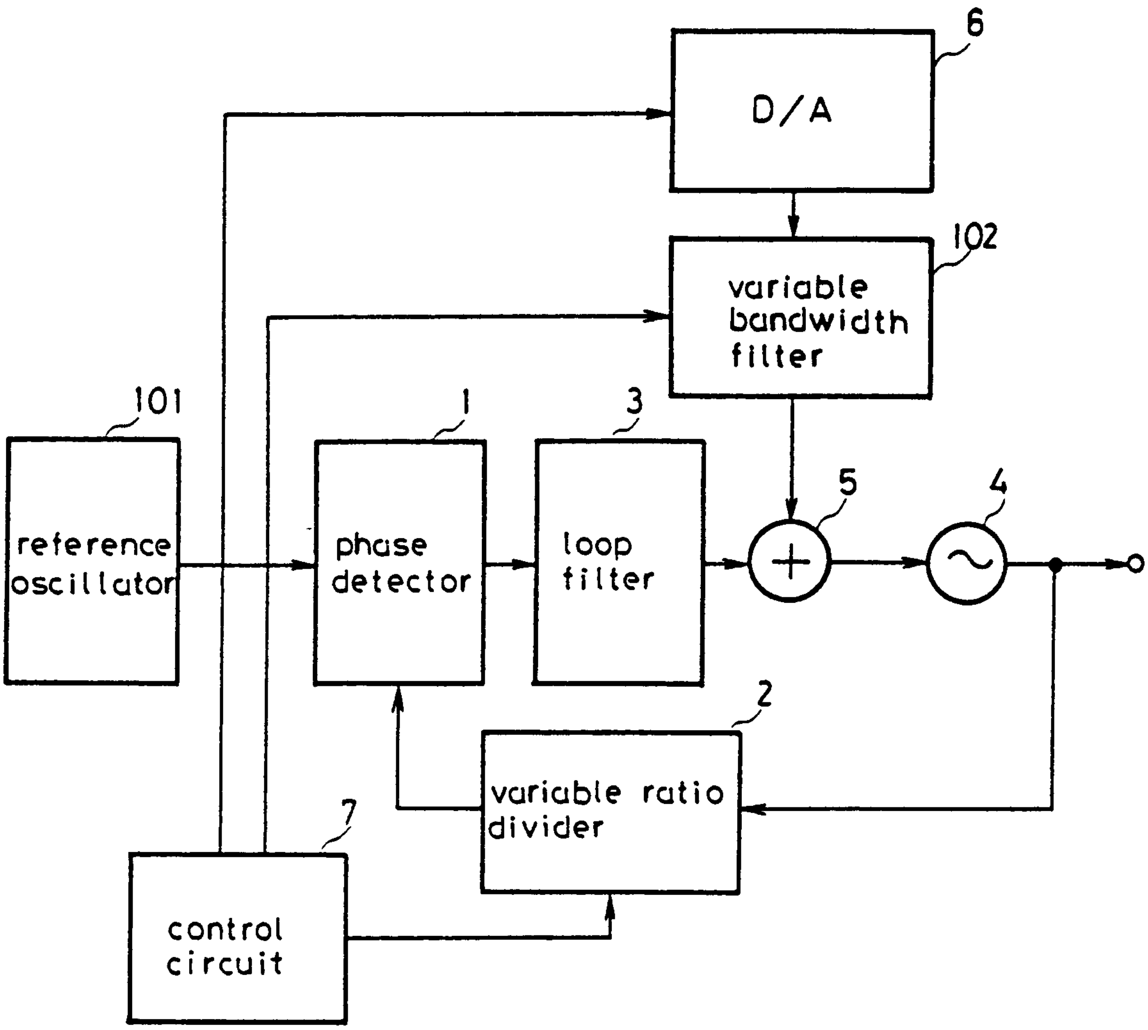


FIG. 17

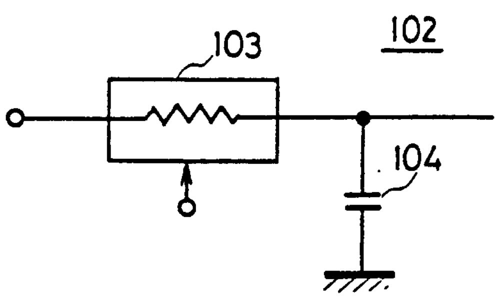


FIG. 18

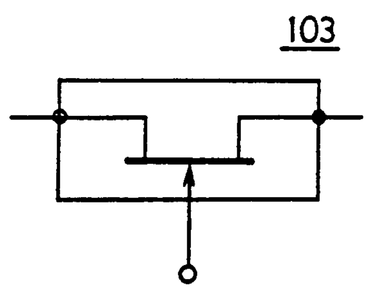


FIG. 19

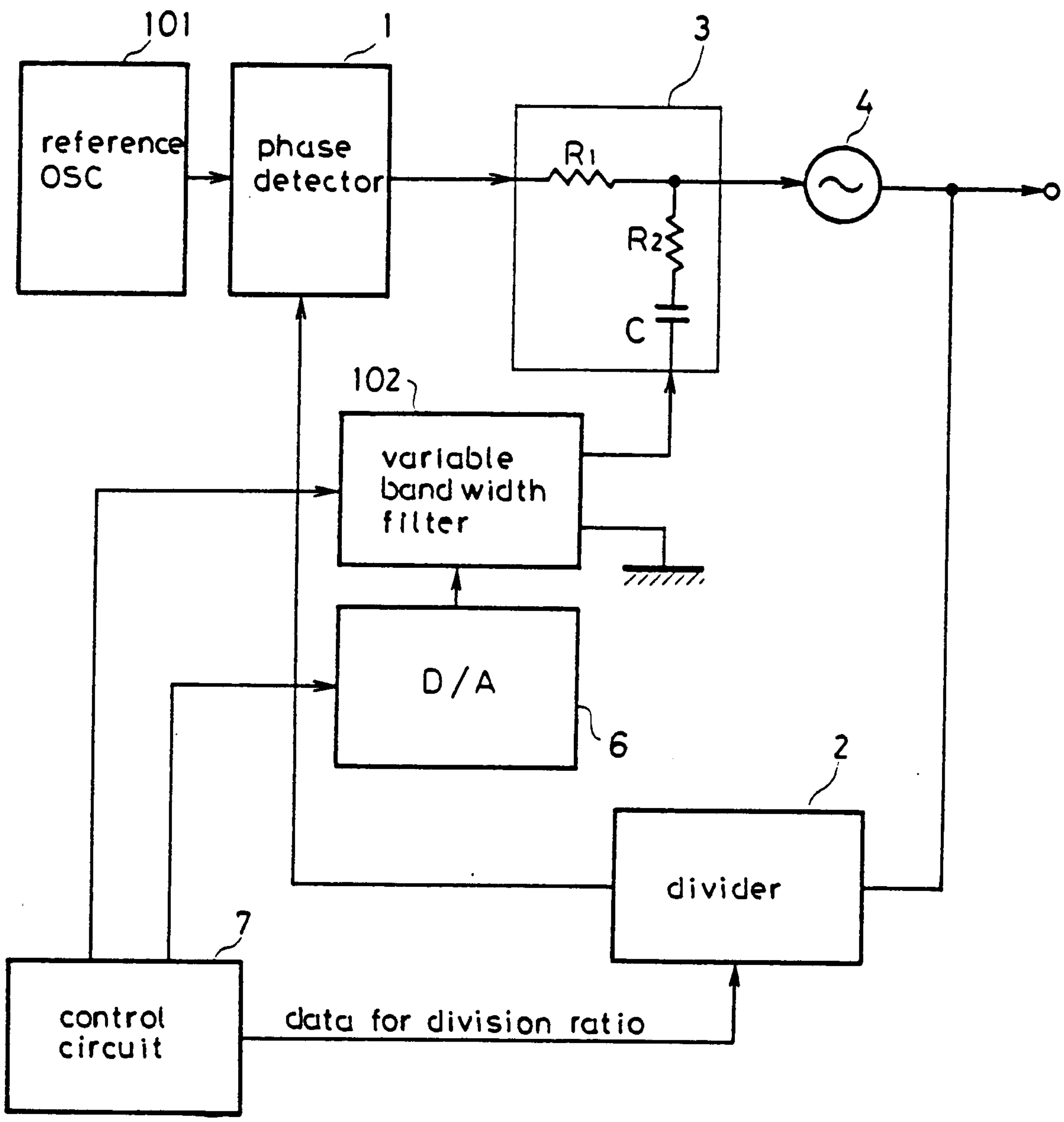
101
1
3
4
reference OSC
phase detector
R1
R2
C
102
variable band width filter
D/A
6
2
divider
7
control circuit
data for division ratio

FIG. 20

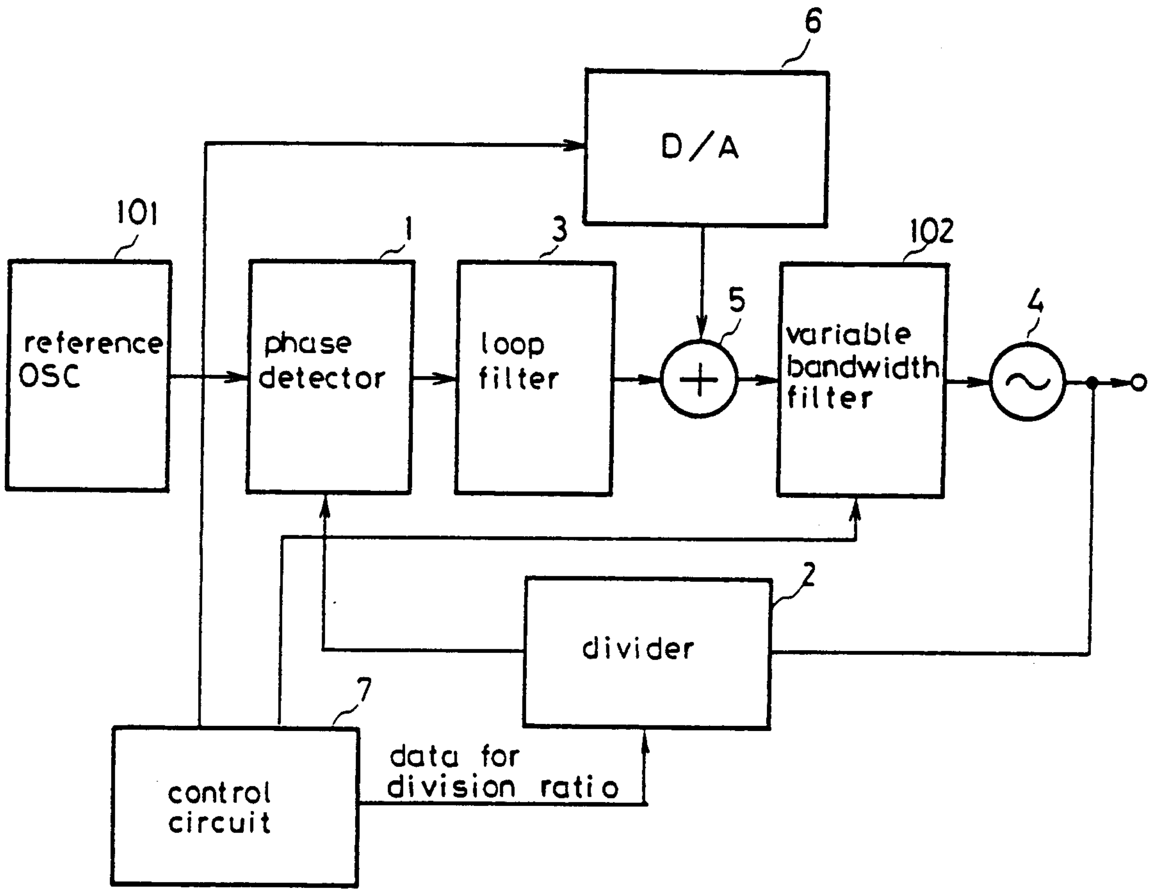
6
D/A
101
reference OSC
1
phase detector
3
loop filter
5
102
variable bandwidth filter
4
2
divider
7
control circuit
data for division ratio

FIG. 21

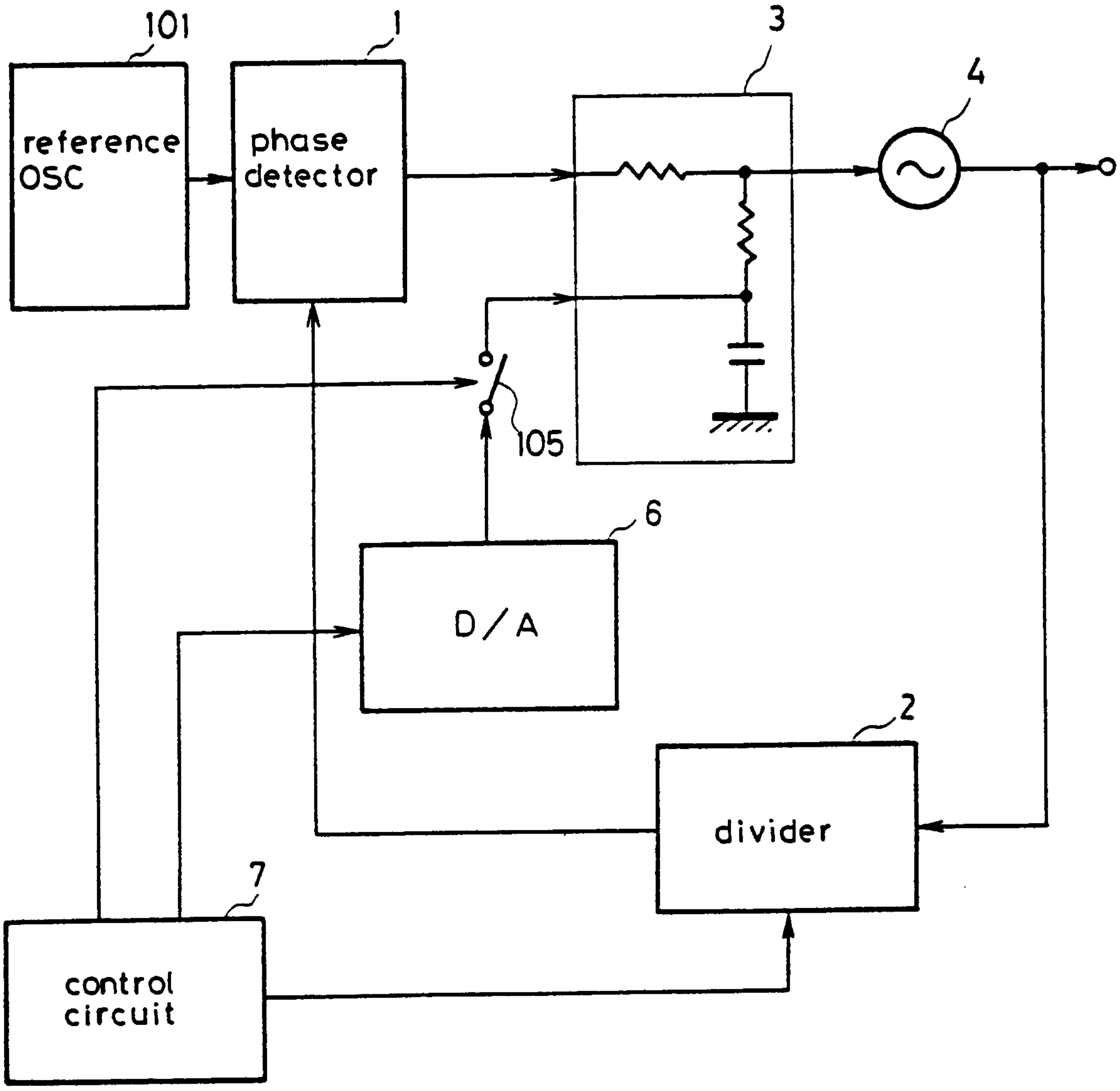
101
1
3
4
reference OSC
phase detector
105
6
D/A
2
divider
7
control circuit

FIG. 22

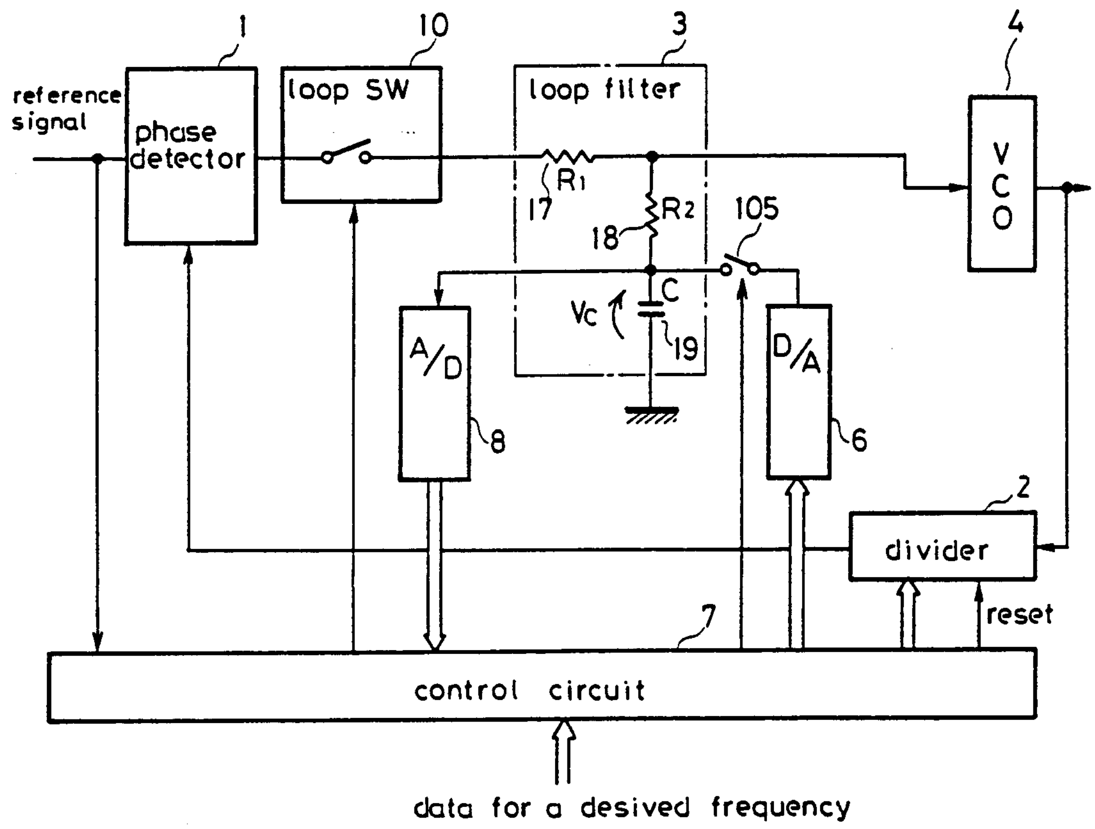
1
10
3
4
reference signal
phase detector
loop SW
loop filter
R1
17
R2
18
105
C
Vc
19
VCO
A/D
8
D/A
6
2
divider
reset
7
control circuit
data for a desived frequency

FIG. 23

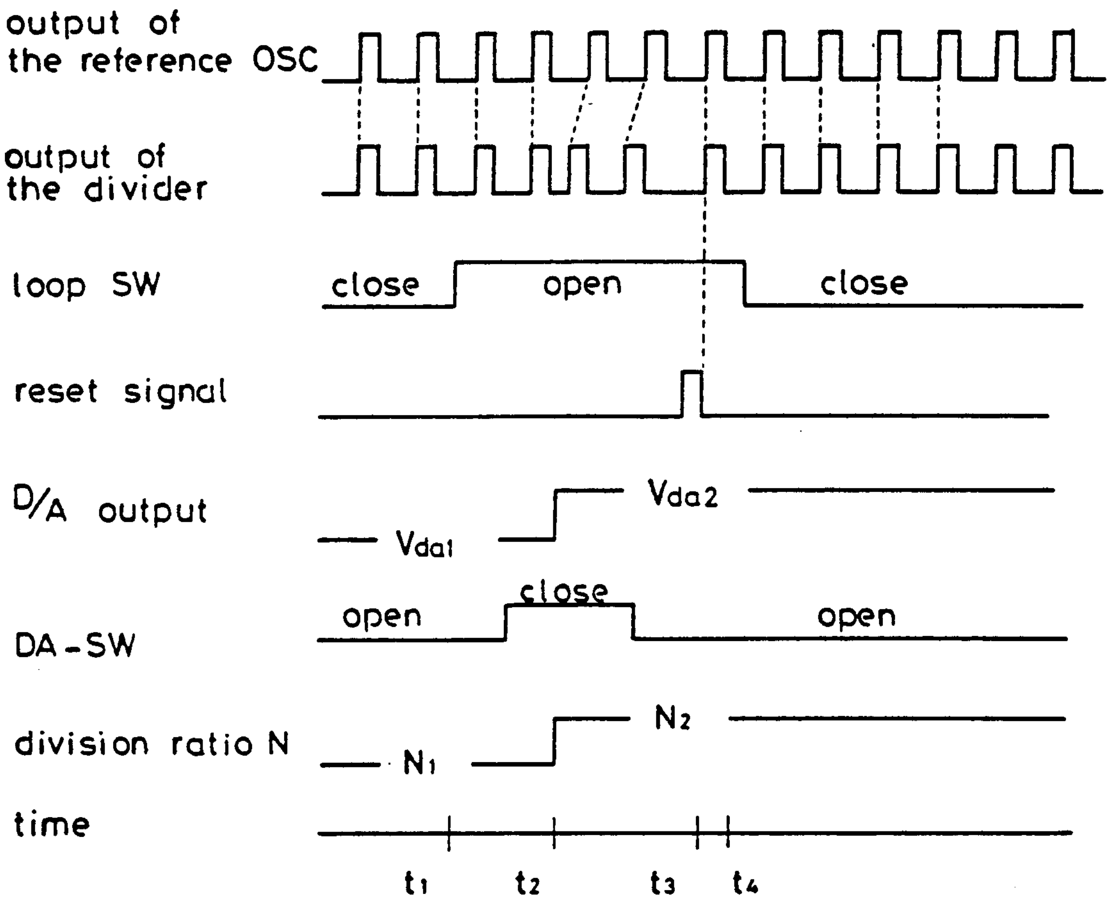
output of
the reference OSC
output of
the divider
loop SW
close
open
close
reset signal
D/A output
Vda1
Vda2
DA-SW
open
close
open
division ratio N
N1
N2
time
t1
t2
t3
t4

FIG. 24

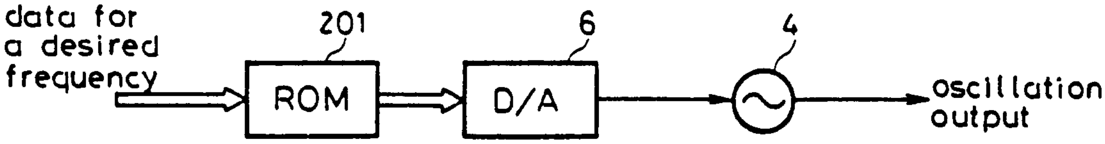


FIG.25

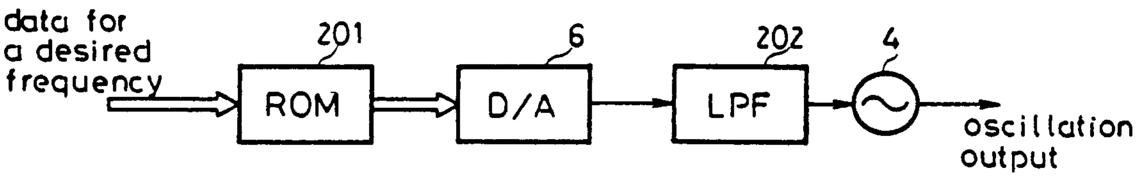


FIG. 26

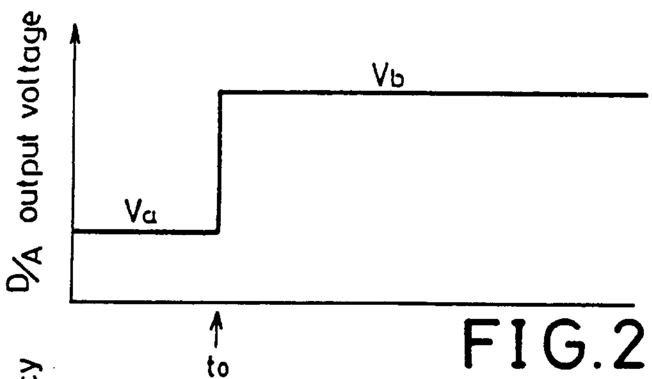


FIG.27(a)

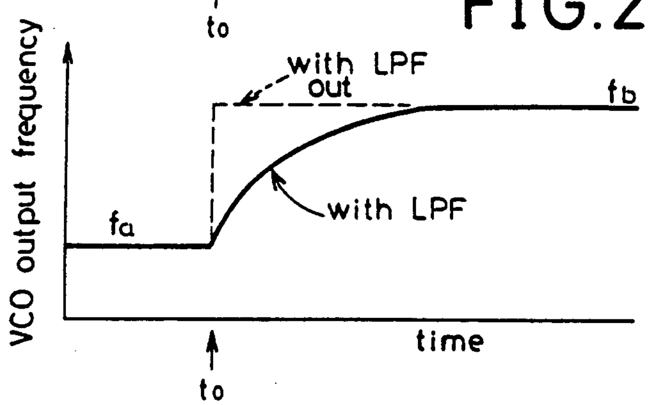


FIG. 27(b)

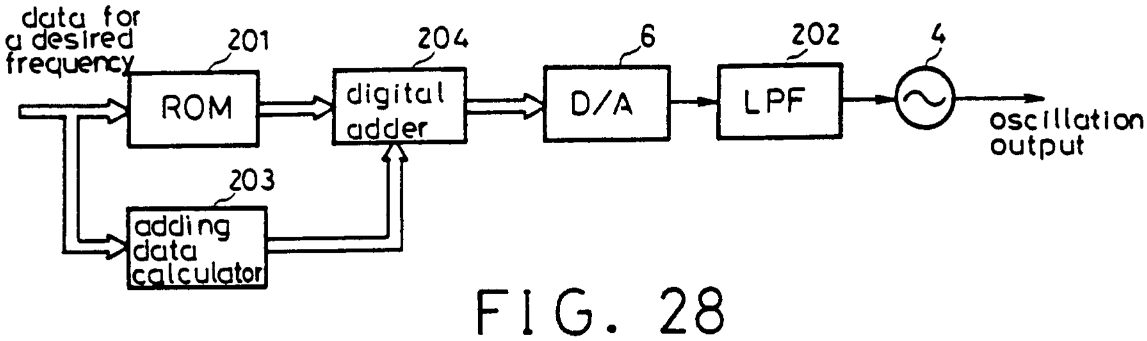


FIG. 28

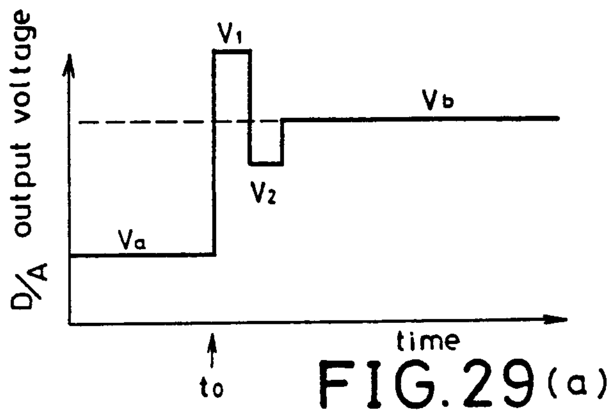


FIG.29(a)

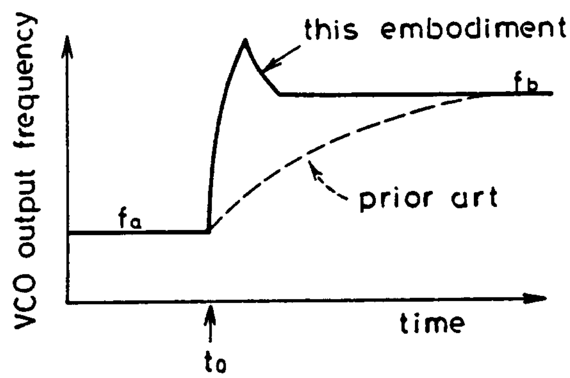


FIG. 29(b)

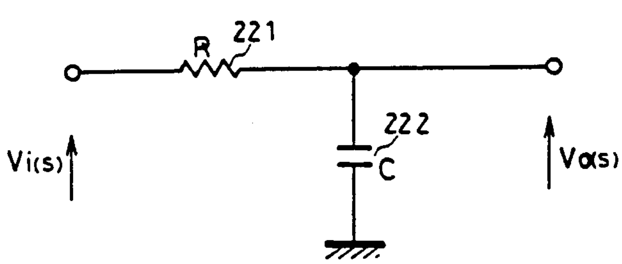


FIG. 30

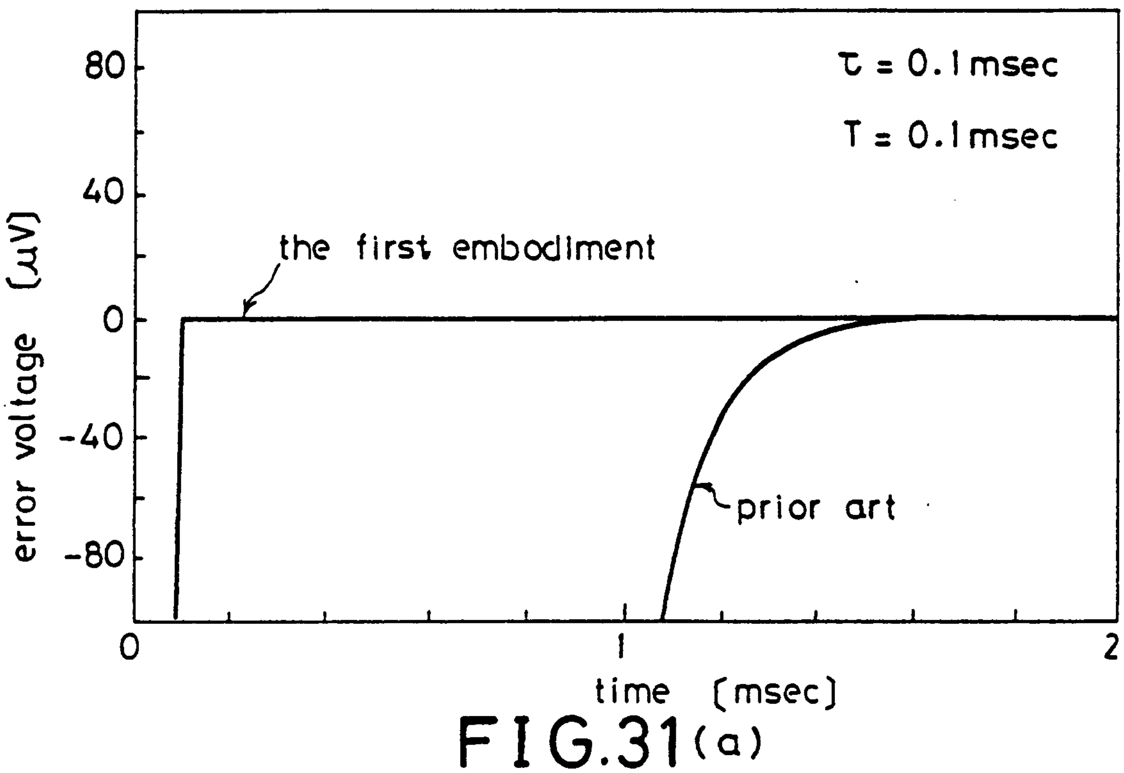


FIG.31(a)

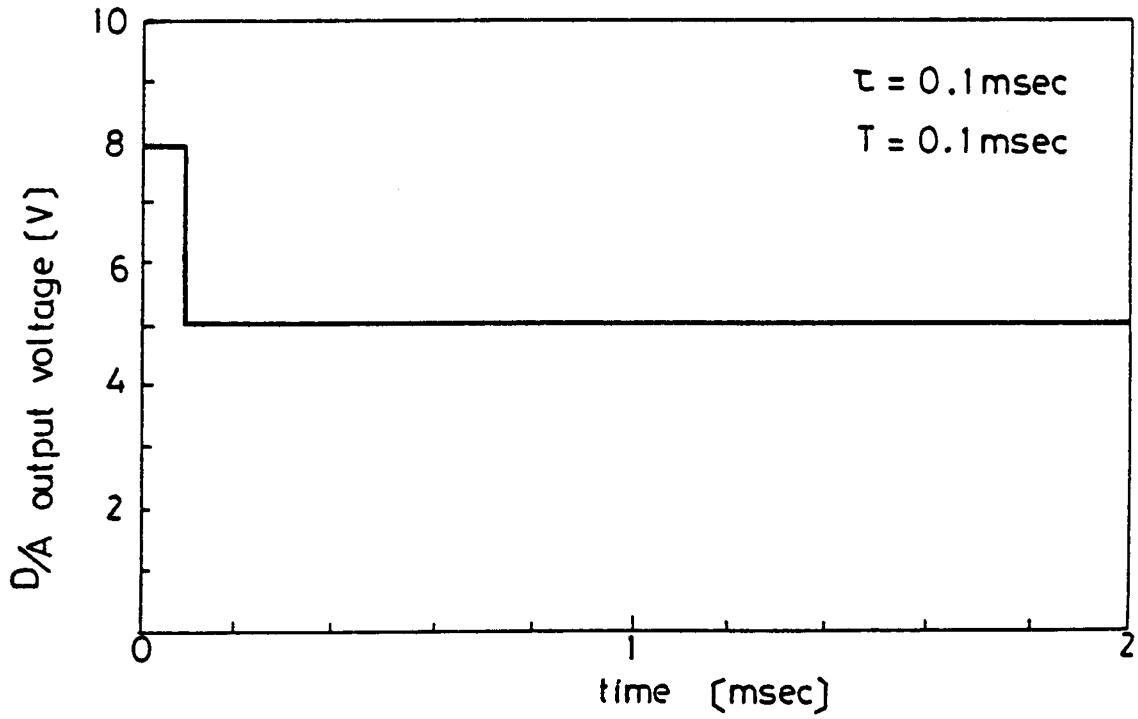


FIG. 31(b)

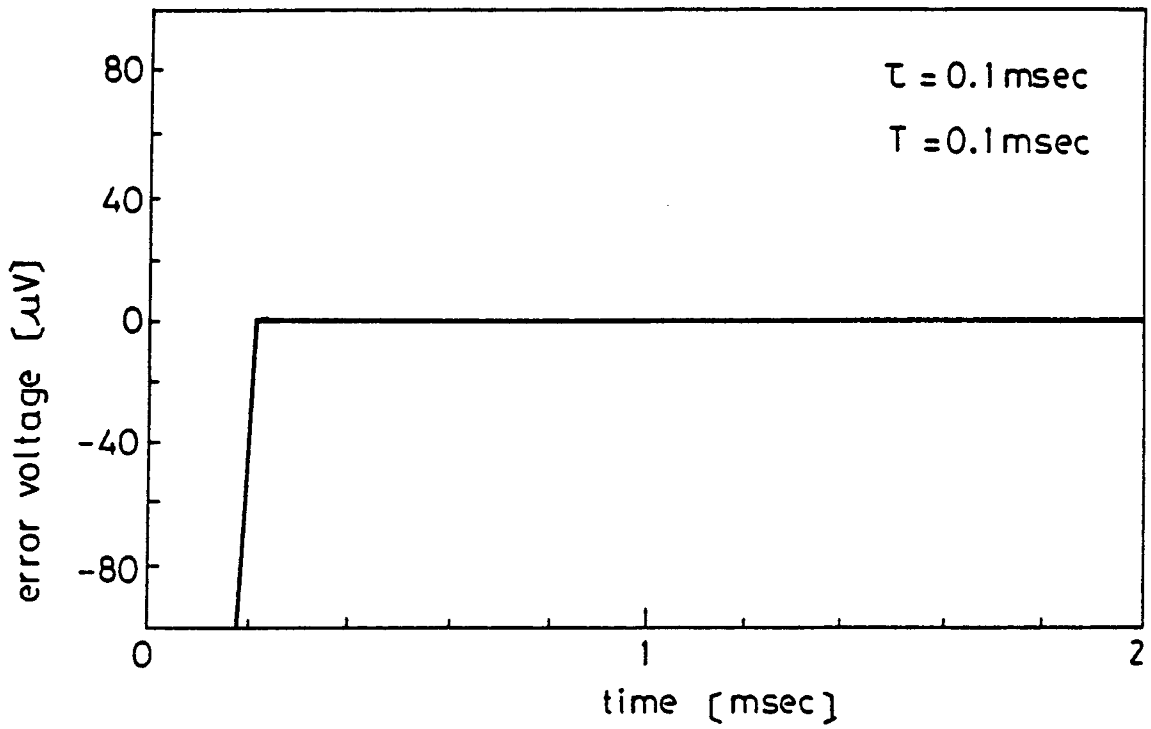


FIG.32(a)

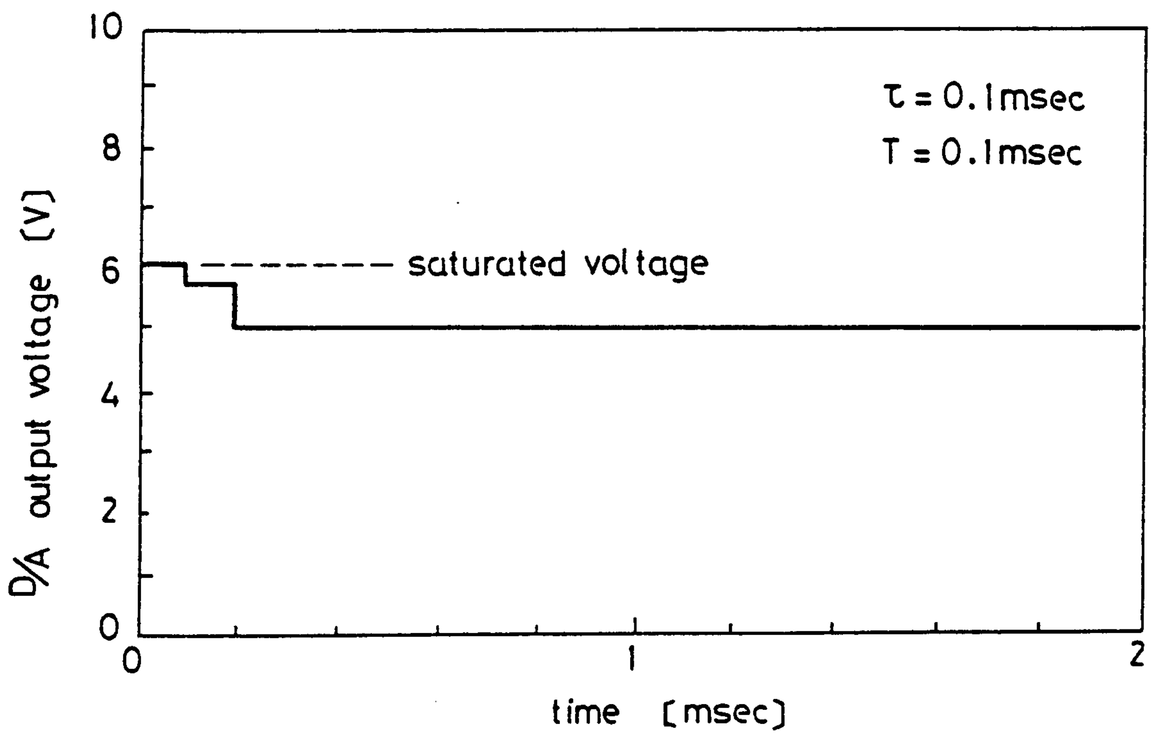


FIG. 32(b)

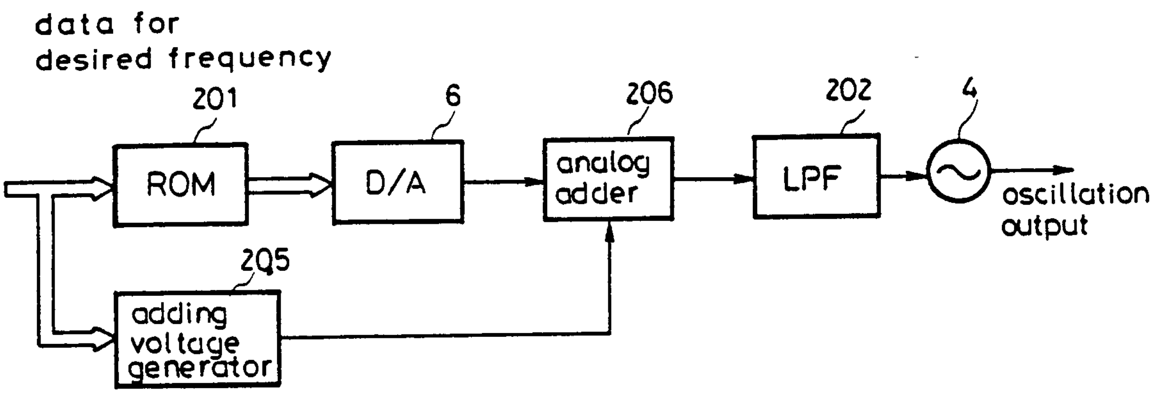
data for
desired frequency
201
ROM
6
D/A
206
analog
adder
202
LPF
4
oscillation
output
205
adding
voltage
generator

FIG. 33

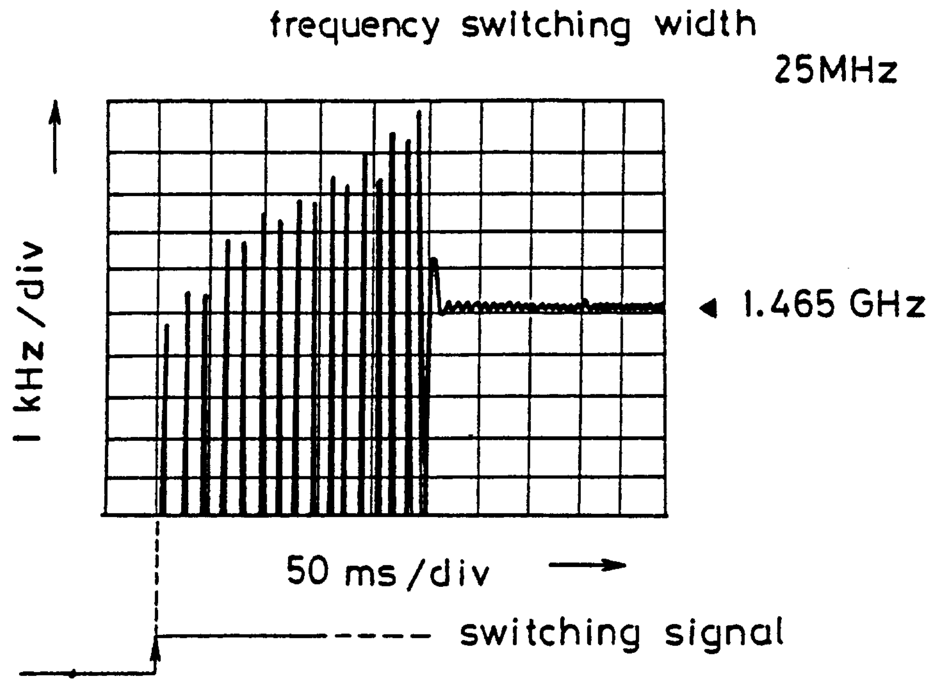
frequency switching width
25MHz
1 kHz/div
◄ 1.465 GHz
50 ms/div
switching signal

FIG. 34

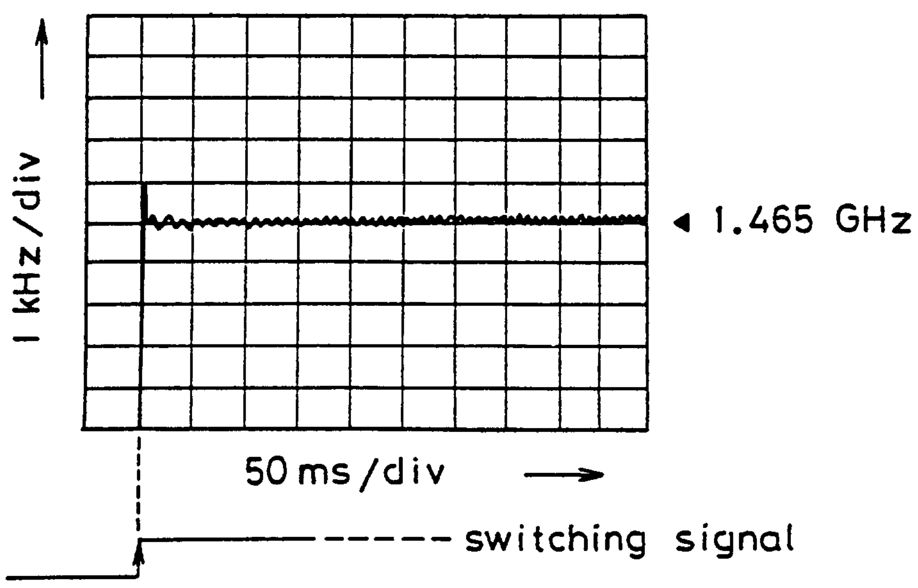
1 kHz/div
◄ 1.465 GHz
50 ms/div
switching signal

FIG. 35